# EUROPEAN PATENT APPLICATION

(11) **EP 4 687 168 A1**
(43) Date of publication of application: **04.02.2026**
(21) Application number: 25192724.0
(22) Date of filing: 30.07.2025
(51) Int. Cl.: H01J 37/04, H01J 37/295

(54) **METHODS OF OPERATING A CHARGED PARTICLE MICROSCOPE SYSTEM INCLUDING A BEAM DEFLECTOR AND ASSOCIATED SYSTEMS**

(30) Priority: 30.07.2024 US 202418789303
(71) Applicant: FEI Company, Hillsboro, OR 97124-5793 (US)
(72) Inventor: VAN RIJT, Mark, Eindhoven (NL); KIEFT, Erik, Eindhoven (NL)
(74) Representative: Boult Wade Tennant LLP

(57) **Abstract**

In an example, a method includes adjusting one or more optical elements such that a deflector plane of a beam deflector is conjugate to a diffraction plane and recording a diffracted beam pattern at the diffraction plane. In another example, a method includes directing a charged particle beam to a specimen. transitioning a beam blanker between blanked and unblanked states, and recording a beam pattern with a detector. The beam pattern includes one or more beam pattern features that are substantially stationary in a detector plane as the beam blanker transitions between the unblanked and blanked state. In another example, a CPM system includes a charged particle source, a beam deflector at a deflector plane, and a detector. The CPM system is configured such that a charged particle beam exhibits a beam crossover at the deflector plane and such that the deflector plane is imaged onto the detector.

## Description

### FIELD

The present disclosure relates generally to methods of operating a charged particle microscope that includes a beam deflector, and more specifically to methods of configuring a transmission electron microscope for use in conjunction with a beam deflector in electron diffraction experiments.

### BACKGROUND

Charged particle microscopy is a well-known and increasingly important technique for imaging microscopic objects, particularly in the form of electron microscopy. The basic genus of the electron microscope finds practical application in the form of a variety of apparatus species, such as the Transmission Electron Microscope (TEM), Scanning Electron Microscope (SEM), and Scanning Transmission Electron Microscope (STEM), and also into various sub-species.

In a SEM, irradiation of a specimen by a scanning electron beam precipitates emanation of "auxiliary" radiation from the specimen in the form of secondary electrons, backscattered electrons, X-rays, and cathodoluminescence (infrared, visible and/or ultraviolet photons), for example. One or more components of this emanating radiation is/are then detected and used for image accumulation purposes.

As an alternative to the use of electrons as irradiating beam, charged particle microscopy can also be performed using other species of charged particle. In this respect, the phrase "charged particle" may be understood as encompassing electrons, positive ions (e.g., Ga or He ions), negative ions, protons, and positrons, for example. In addition to imaging and performing (localized) surface modification (e.g., milling, etching, deposition, etc.), a charged particle microscope also may have other functionalities, such as performing spectroscopy, examining diffractograms, etc.

In all cases, a charged particle microscope (CPM) generally will comprise at least a radiation source (e.g., an electron source or ion gun), a beam directing system, a specimen holder, and a detector.

The detector can take many different forms depending on the radiation being detected. Examples include photodiodes, CMOS detectors, CCD detectors, photovoltaic cells, X-ray detectors (such as Silicon Drift Detectors and Si(Li) detectors), etc. In general, a CPM may comprise several different types of detectors, selections of which can be invoked in different situations. It generally is desirable that the detector exhibit a sufficiently broad dynamic range to represent a wide range of incident charged particle signal magnitudes.

While the present disclosure generally pertains to the specific context of charged particle microscopy, and more specifically to transmission electron microscopy, such descriptions are not intended to be limiting, and it is within the scope of the present disclosure that the apparatuses and methods disclosed herein may be applied in any suitable context.

### SUMMARY

Methods of operating a charged particle microscope (CPM) system including a beam deflector and associated systems are disclosed herein.

In a representative example, a method of operating a CPM system includes adjusting one or more optical elements of the CPM system such that a deflector plane at which a beam deflector is positioned is conjugate to a diffraction plane at which a charged particle beam that is directed to a specimen produces a diffracted beam pattern. The method additionally includes recording the diffracted beam pattern with a detector positioned at the diffraction plane.

In another representative example, a method of operating a CPM system includes directing a charged particle beam to a specimen that modulates the charged particle beam to create a beam pattern downstream of the specimen. The method additionally includes transitioning a beam blanker of the CPM system between an unblanked state and a blanked state. The beam blanker is positioned at a deflector plane. When the beam blanker is in the unblanked state, the charged particle beam reaches the specimen. When the beam blanker is in the blanked state, the charged particle beam is directed away from the specimen. The method additionally includes recording the beam pattern with a detector positioned at a detector plane that is conjugate to the deflector plane. The beam pattern includes one or more beam pattern features that are focused in the detector plane. The one or more beam pattern features are substantially stationary in the detector plane as the beam blanker transitions between the unblanked state and the blanked state.

In another representative example, a CPM system includes a charged particle source, a first optical assembly positioned downstream of the charged particle source, and a beam deflector positioned at a deflector plane downstream of the first optical assembly. The charged particle source is configured to emit a charged particle beam along an optical axis toward a specimen. The beam deflector is configured to selectively divert the charged particle beam away from the specimen. The CPM system additionally includes a second optical assembly positioned downstream of the deflector plane and a detector positioned at a detector plane downstream of the second optical assembly. The CPM system is configured such that the charged particle beam exhibits a beam crossover at the deflector plane and such that the deflector plane is imaged onto the detector.

The foregoing and other objects, features, and advantages of the disclosed technology will become more apparent from the following detailed description, which proceeds with reference to the accompanying figures.
Further aspects of the invention are set out in the following numbered clauses:
1. A method of operating a charged particle microscope (CPM) system comprising a beam deflector positioned at a deflector plane, the CPM system configured to direct a charged particle beam to a specimen to produce a diffracted beam pattern at a diffraction plane, the method comprising:
   adjusting one or more optical elements of the CPM system such that the deflector plane is conjugate to the diffraction plane; and
   recording the diffracted beam pattern with a detector positioned at the diffraction plane.
2. The method of clause 1, wherein the adjusting the one or more optical elements comprises adjusting a position of the diffraction plane to bring the diffraction plane into axial alignment with the detector.
3. The method of clause 2, wherein the CPM system comprises a first optical assembly positioned upstream of the deflector plane and a second optical assembly positioned downstream of the deflector plane, wherein the adjusting the position of the diffraction plane comprises adjusting one or more optical elements of the second optical assembly, and wherein the method further comprises adjusting one or more optical elements of the first optical assembly to bring a crossover plane of the charged particle beam into axial alignment with the detector.
4. The method of clause 3, wherein the adjusting the one or more optical elements of the first optical assembly is performed subsequent to the adjusting the one or more optical elements of the second optical assembly.
5. The method of clause 3, wherein the adjusting the one or more optical elements of the first optical assembly comprises adjusting a first focal length associated with the first optical assembly, and wherein the adjusting the one or more optical elements of the second optical assembly comprises adjusting a second focal length associated with the second optical assembly.
6. The method of clause 3, wherein the CPM system comprises a source optics assembly configured to accelerate the charged particle beam toward the specimen, and wherein the first optical assembly comprises at least a portion of the source optics assembly.
7. The method of clause 3, wherein the second optical assembly comprises at least a portion of a condenser optics assembly of the CPM system.
8. The method of clause 3, wherein the second optical assembly comprises at least a portion of an objective optics assembly.
9. The method of clause 3, wherein the adjusting the position of the diffraction plane comprises shifting the position of the diffraction plane in an axial direction.
10. The method of clause 1, wherein the CPM system is configured such that the charged particle beam is at least substantially undeflected by the beam deflector when the beam deflector is in an unblanked state, wherein the beam deflector is configured to selectively deflect the charged particle beam away from the specimen when the beam deflector is in a fully blanked state, wherein the beam deflector is configured to direct the charged particle beam along a trajectory that yields a partially blanked beam pattern at the diffraction plane when the beam deflector is in any of a plurality of partially blanked states defined between the unblanked state and the fully blanked state, and wherein the method comprises operating the CPM system such that the partially blanked beam pattern is substantially stationary in the deflector plane as the beam deflector transitions from the unblanked state to the fully blanked state.
11. A method of operating a charged particle microscope (CPM) system, the method comprising:
   directing a charged particle beam to a specimen that modulates the charged particle beam to create a beam pattern downstream of the specimen;
   transitioning a beam blanker of the CPM system that is positioned at a deflector plane between an unblanked state, in which the charged particle beam reaches the specimen, and a blanked state, in which the charged particle beam is directed away from the specimen; and
   recording the beam pattern with a detector positioned at a detector plane that is conjugate to the deflector plane,
   wherein the beam pattern comprises one or more beam pattern features that are focused in the detector plane, and wherein the one or more beam pattern features are substantially stationary in the detector plane as the beam blanker transitions between the unblanked state and the blanked state.
12. The method of clause 11, wherein the transitioning the beam blanker between the unblanked state and the blanked state is performed over a time period that is less than 10 nanoseconds (ns).
13. The method of clause 11, further comprising configuring the CPM system in a conjugate blanking configuration, in which the deflector plane is conjugate to the detector plane and in which a crossover of the charged particle beam is positioned at the deflector plane, and wherein the configuring the CPM system comprises:
   bringing the CPM system to an intermediate configuration, in which the detector plane is conjugate to the deflector plane; and
   subsequent to the bringing the CPM system to the intermediate configuration, bringing the CPM system to the conjugate blanking configuration.
14. The method of clause 13, wherein the bringing the CPM system to the intermediate configuration comprises adjusting a focal length of one or more optical elements downstream of the deflector plane.
15. The method of clause 13, wherein the bringing the CPM system to the intermediate configuration comprises:
   modulating the beam blanker between the unblanked state and the blanked state to move a test beam pattern feature of the one or more beam pattern features in the detector plane; and
   adjusting one or more optical elements downstream of the deflector plane to fix the test beam pattern feature to a location that is substantially stationary in the deflector plane during the modulating the beam blanker between the unblanked state and the blanked state.
16. The method of clause 13, wherein the bringing the CPM system to the conjugate blanking configuration comprises, with the CPM system in the intermediate configuration, focusing the beam pattern to the detector plane.
17. The method of clause 16, wherein the focusing the beam pattern to the detector plane comprises adjusting a focal length of one or more optical elements upstream of the deflector plane.
18. A charged particle microscope (CPM) system, comprising:
   a charged particle source configured to emit a charged particle beam along an optical axis toward a specimen;
   a first optical assembly positioned downstream of the charged particle source and configured to vary an axial position of a focal plane of the charged particle beam upstream of the specimen;
   a beam deflector positioned at a deflector plane downstream of the first optical assembly and configured to selectively divert the charged particle beam away from the specimen;
   a second optical assembly positioned downstream of the deflector plane and configured to vary an axial position of a focal plane of the charged particle beam downstream of the specimen; and
   a detector positioned at a detector plane downstream of the second optical assembly,
   wherein the CPM system is configured such that the charged particle beam exhibits a beam crossover at the deflector plane and such that the deflector plane is imaged onto the detector.
19. The CPM system of clause 18, wherein the first optical assembly comprises a gun lens configured to adjust an axial position of the beam crossover, and wherein the CPM system is configured such that the gun lens remains at a fixed excitation during operative use of the CPM system.
20. The CPM system of clause 18, wherein the second optical assembly comprises one or both of a condenser optics assembly and an objective optics assembly.
21. The CPM system of clause 18, wherein one or more components of the second optical assembly are positioned downstream of the specimen.
22. The CPM system of clause 18, further comprising a blanking aperture, wherein the beam deflector is configured to selectively direct the charged particle beam to be blocked by the blanking aperture.

### BRIEF DESCRIPTION OF THE DRAWINGS

FIG. 1 is a schematic illustration of a charged particle microscope (CPM) system according to an example.
FIG. 2 is a schematic representation of a charged particle beam path through a CPM system according to an example.
FIG. 3A is a schematic representation of paths of a charged particle beam and of a partially deflected beam through a CPM system in an initial configuration according to an example.
FIG. 3B is a schematic representation of paths of a charged particle beam and of a partially deflected particle beam through a CPM system in an intermediate configuration according to an example.
FIG. 3C is a schematic representation of paths of a charged particle beam and of a partially deflected particle beam through a CPM system in a conjugate blanking configuration according to an example.
FIG. 4 is an illustration of a streak formed by an electron beam moving across a detector according to an example.
FIG. 5A is an illustration of a diffraction pattern recorded with a CPM system in an initial configuration according to an example.
FIG. 5B is an illustration of the diffraction pattern of FIG. 5A recorded after bringing the CPM system to a conjugate blanking configuration.
FIG. 6A is an illustration of a diffraction pattern recorded with a CPM system in an initial configuration according to another example.
FIG. 6B is an illustration of the diffraction pattern of FIG. 6A recorded after bringing the CPM system to a conjugate blanking configuration.
FIG. 7 is a flow chart depicting a method of operating a CPM system according to an example.
FIG. 8 is a flow chart depicting a method of operating a CPM system according to another example.
FIG. 9 is a schematic representation of a computing system that may be used to perform one or more methods of the present disclosure according to an example.

### DETAILED DESCRIPTION

The present disclosure generally is directed to methods of configuring and/or operating a CPM system, such as a TEM, in a manner that reduces and/or eliminates undesirable variation in a diffraction pattern when operating a beam deflector to blank or unblank the charged particle beam. As described in more detail below, such a beam deflector may operate by selectively directing the charged particle beam to intercept a blanking structure such as an aperture prior to reaching the specimen.

A CPM system may employ a beam deflector for any of a variety of purposes. As an example, a beam deflector can selectively divert the charged particle beam away from the specimen in order to shield sensitive specimens from the charged particle beam when the CPM system is not actively imaging the specimen. As another example, toggling such a beam deflector between the blanked and unblanked states can enable transmitting the charged particle beam to the specimen in the form of pulses of controlled duration. For example, when using sufficiently fast beam deflectors, it is possible to generate charged particle beam pulses on the microsecond, nanosecond, or even sub-nanosecond time scales. Recording signals (e.g., in the form of diffraction patterns) that are created by charged particle pulses that traverse the specimen can be used in damage mitigation studies and/or in time-resolved studies of specimen behavior in a pump-probe setup.

A beam deflector generally may be characterized by a transition time for transitioning between a fully blanked state and a fully unblanked state. In many examples, the blanking or unblanking of the charged particle beam can cause the diffracted charged particle beam to move in a diffraction plane in which the diffraction pattern is recorded, thus causing a visible streaking of the diffraction pattern during such time periods. In applications in which the charged particle beam pulse length is short relative to the characteristic transition time of the beam deflector, such streaking may be increasingly evident in an exposure capturing the recorded diffraction pattern, thus introducing a limit to the precision with which the intended diffraction pattern may be recorded.

The present disclosure thus is directed to methods of configuring a CPM system such that features of the diffraction pattern are at least substantially stationary in the diffraction plane in which the diffraction pattern is recorded. As described in more detail below, this may be accomplished by positioning the beam deflector in a plane that is conjugate to the diffraction plane. Examples of methods for achieving such a configuration are described below.

### Exemplary Systems

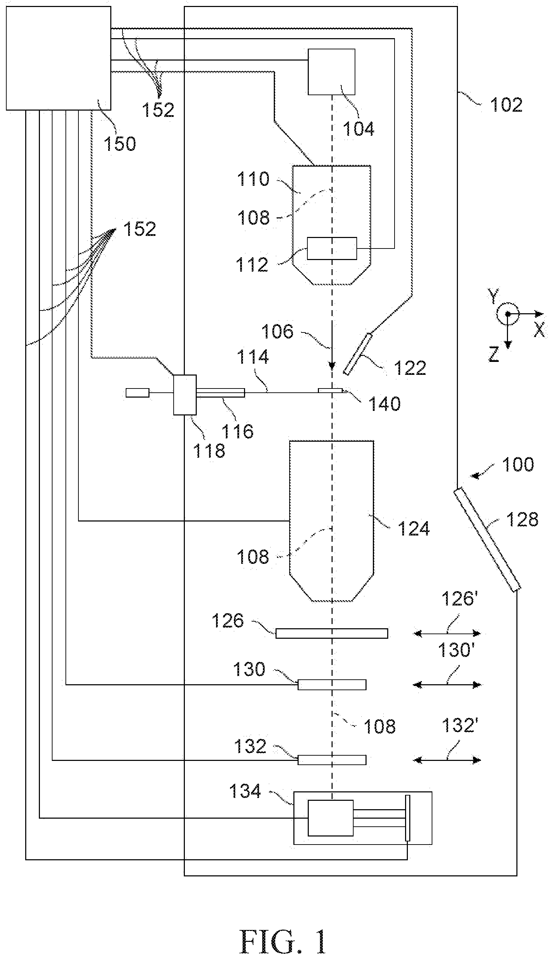

FIG. 1 depicts an example of a CPM system 100 that may be used in the performance of aspects of the methods disclosed herein. In particular, FIG. 1 illustrates a CPM system in the form of a transmission electron microscope (TEM).

As illustrated in FIG. 1, the CPM system 100 comprises a vacuum enclosure 102 and an electron source 104 (e.g., a Schottky emitter) positioned in the vacuum enclosure 102. The electron source 104 produces an electron beam 106 that traverses an illuminator 110, which directs and/or focuses the electron beam 106 onto a portion of a specimen 140. This illuminator 110 has an optical axis 108 and can comprise any of a variety of electrostatic/magnetic lenses, deflector(s) 112, correctors (such as stigmators), etc. The illuminator 110 also can comprise and/or be a condenser system.

In the example of FIG. 1, the specimen 140 is held on a specimen holder 114. As here illustrated, a portion of the specimen holder 114 extends within the enclosure 102 and is mounted in a cradle 116 that can be positioned/moved in multiple degrees of freedom by a positioning device (stage) A. For example, the cradle 116 may be displaceable in the X, Y, and Z directions depicted in FIG. 1, and/or may be rotated about a longitudinal axis parallel to the X direction. Such movement can allow different parts of the specimen 140 to be irradiated/imaged/inspected by the electron beam 106 traveling along the optical axis 108. Such motion additionally or alternatively can allow selected parts of the specimen 140 to be machined by a (non-depicted) focused ion beam, for example. Additionally or alternatively, in some examples, the electron beam 106 can be scanned relative to the specimen 140 with one or more deflectors 112.

The (focused) electron beam 106 traveling along the optical axis 108 can interact with the specimen 140 in such a manner as to cause various types of "stimulated" radiation to emanate from the specimen 140, including (for example) secondary electrons, backscattered electrons, X-rays and optical radiation (cathodoluminescence). One or more of these radiation types can be detected with the aid of a sensor 122, which might be a combined scintillator/photomultiplier or EDX (Energy-Dispersive X-Ray Spectroscopy) module, for instance. In such an example, an image could be constructed using basically the same principle as in a SEM. Additionally or alternatively, one can study electrons that traverse (pass through) the specimen 140, emerge (emanate) from it, and continue to propagate (substantially, though generally with some deflection/scattering) along the optical axis 108. Such a transmitted electron flux enters an imaging system (e.g., a combined objective/projection lens) 124, which can comprise a variety of electrostatic/magnetic lenses, deflectors, correctors (such as stigmators), etc.

In normal (non-scanning) TEM mode, this imaging system 124 can focus the transmitted electron flux onto a fluorescent screen 126, which, if desired, can be retracted/withdrawn (as schematically indicated by arrows 126') relative to the optical axis 108. An image (e.g., a diffractogram) of at least a portion of the specimen 140 will be formed by the imaging system 124 on the screen 126, and this may be viewed through a viewing port 128 located in a suitable part of a wall of the enclosure 102. The retraction mechanism for the screen 126 may, for example, be mechanical and/or electrical in nature.

Additionally or alternatively, and as shown in FIG. 1, the CPM system 100 can include a TEM camera 130. At the TEM camera 130, the electron flux can form a static image (or diffractogram) that can be processed by a controller 150 and displayed on a display device, such as a flat panel display, for example. When not required, the TEM camera 130 can be retracted/withdrawn (as schematically indicated by arrows 130') relative to the optical axis 108.

Additionally or alternatively, and as shown in FIG. 1, the CPM system 100 can include a STEM detector 132. An output from the STEM detector 132 can be recorded as a function of (X,Y) scanning position of the electron beam 106 on the specimen 140, and an image can be constructed that is a "map" of output from the STEM detector 132 as a function of (X,Y). In existing tools, the STEM detector 132 can comprise a single pixel with a diameter of e.g., 20 mm, as opposed to the matrix of pixels characteristically present in the TEM camera 130. Once again, when not required, the STEM detector 132 can be retracted/withdrawn (as schematically indicated by arrows 232') relative to the optical axis 108.

Additionally or alternatively, and as shown in FIG. 1, the CPM system 100 can include a spectroscopic apparatus 134, which can include and/or be an EELS module, for example.

It should be noted that the order/location of items 130, 132 and 134 is not strict, and many possible variations are conceivable. For example, the spectroscopic apparatus 134 can also be integrated into the imaging system 124.

The controller/computer processor 150 is connected to various illustrated components via control lines (buses) 152. This controller 150 can provide a variety of functions, such as synchronizing actions, providing setpoints, processing signals, performing calculations, and displaying messages/information on a display device (not depicted in FIG. 1). The controller 150 may be positioned at least partially inside or outside the enclosure 102, and may have a unitary or composite structure, as desired. The skilled artisan will understand that the interior of the enclosure 102 does not have to be kept at a strict vacuum. For example, in a so-called "Environmental (S)TEM," a background atmosphere of a given gas is deliberately introduced/maintained within the enclosure 102. The skilled artisan also will understand that, in practice, it may be advantageous to confine the volume of enclosure 102 so that, where possible, it essentially extends minimally away from the axis 108, taking the form of a small tube (e.g., of the order of 1 cm in diameter) through which the employed electron beam passes, but widening out to accommodate structures such as the source 104, the specimen holder 114, the screen 126, the camera 130, the detector 132, the spectroscopic apparatus 134, etc.

In some examples, the illuminator 110 may comprise a beam shaping element such as a lens and/or aperture plate/diaphragm, to appropriately shape (focus) the beam 106 into a relatively narrow "pencil" of charged particles, causing it to irradiate only a relatively small area (footprint) of the specimen 140 at any given time. Relative motion between the specimen 140 and the footprint of the beam 106 to move the footprint onto another area of the specimen can be produced in any of a variety of manners, such as by using the positioning device 118 to move the specimen 140 relative to the beam 106 and/or by using the deflector 112 to deflect the beam 106 relative to the specimen 140; moving the source 104 or/and the abovementioned beam shaping element so as to displace the beam 106 relative to the specimen 140.

In some examples, for each such chosen position of the electron beam 106 relative to the specimen 140, one can use the TEM camera 130 to capture a diffractogram (diffraction pattern). Specifically, the controller 150 (or another processor device) can be programmed and/or configured to acquire a ptychographic measurement set, by recording an output of (for example) the TEM camera 130 for each of a series of different positions of the beam 106 upon the specimen 140 (achieved, for example, by sending an appropriate series of setpoints to the positioning device 118, the deflector 112, etc.). Additionally or alternatively, the controller 150 can be programmed and/or configured to process the recorded outputs of said camera 130 and use them as input to perform a mathematical reconstruction algorithm. Additionally or alternatively, the controller 150 can be programmed and/or configured to display the results of said reconstruction algorithm, e.g., in the form of an image on a display device (not shown).

### Conjugate Blanking Configuration

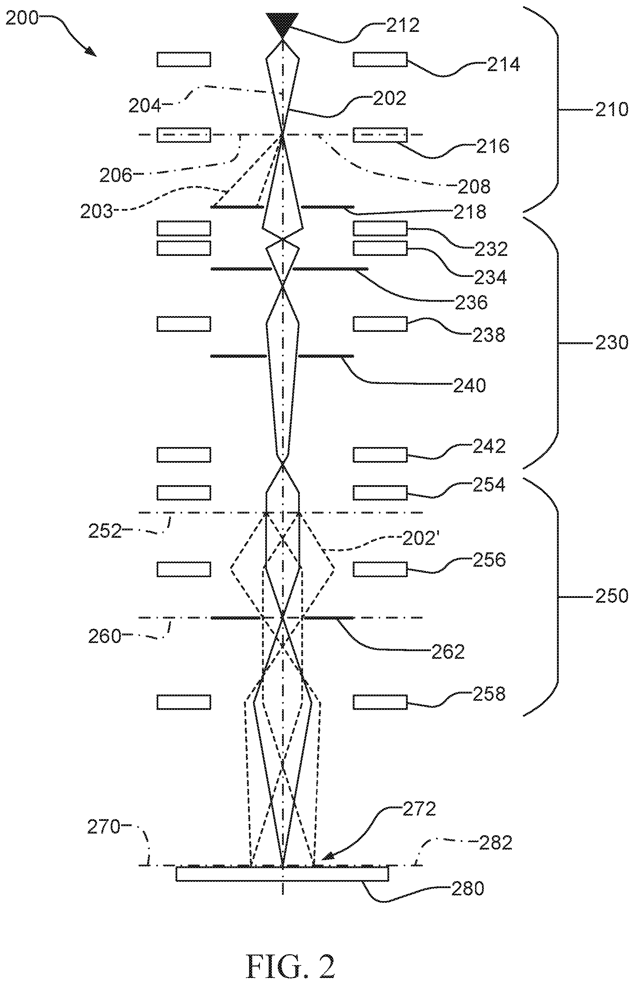

FIG. 2 illustrates aspects of an electron beam 202 that traverses elements of a TEM 200 that is configured in accordance with the present disclosure. The TEM 200 may be described as representing an example of the CPM system 100 of FIG. 1 and may share any components, attributes, etc. with the CPM system 100 of FIG. 1.

While the present disclosure generally relates to examples in which the CPM system under consideration is a TEM (e.g., the TEM 200) and in which the charged particle beam is an electron beam (e.g., the electron beam 202), this is not required of all examples. For example, it also is within the scope of the present disclosure that the methods and concepts disclosed herein may be applicable to any suitable CPM systems and/or other optical systems, such as STEM, SEM, and/or optical microscope systems.

As shown in FIG. 2, the TEM 200 includes a source module 210 with an electron source 212, such as a field emission gun, that emits the electron beam 202 along an optical axis 204 toward a specimen plane 252 at which a specimen is positioned. The electron beam 202 is focused by a gun lens 214 such that the electron beam 202 exhibits a beam crossover at a crossover plane 206. The source module 210 additionally or alternatively may be referred to as a source optics assembly 210.

The source module 210 additionally includes a source module aperture 218 configured to block a portion of the electron beam 202 for any of a variety of purposes. For example, in some examples, the source module 210 can include a monochromater (not depicted in FIG. 2) that disperses the electron beam 202 by varying degrees on the basis of electron energy, and the source module aperture can be configured to block all but a portion of the electron beam 202 corresponding to a desired energy range. Additionally, or alternatively, the source module aperture 218 can include and/or operate in conjunction with a beam deflector 216, as described in more detail below.

The TEM 200 additionally includes a condenser module 230 downstream of the source module 210 that shapes and/or otherwise configures the electron beam 202 prior to reaching the specimen plane 252. The condenser module 230 includes a first condenser lens 232, a second condenser lens 234, a third condenser lens 238, and a fourth condenser lens 242, as well as a first condenser aperture 236 and a second condenser aperture 240. The condenser module 230 additionally or alternatively may be referred to as a condenser optics assembly 230.

The first condenser lens 232, the second condenser lens 234, the third condenser lens 238, and/or the fourth condenser lens 242 can be used in conjunction with the first condenser aperture 236 and/or the second condenser aperture 240 to control various properties of the electron beam 202 that is directed to the specimen, such as the diameter, collimation, and/or energy flux of the electron beam 202. For example, the relative strengths of the first condenser lens 232 and the second condenser lens 234 can determine the diameter and/or beam flux of the electron beam 202 in the plane of the first condenser aperture 236. The second condenser lens 234 and the third condenser lens 238 can be adjusted together to vary the diameter and/or collimation of the electron beam 202 in the specimen plane 252. The fourth condenser lens 242 can be used to change the magnification of the condenser module 230. The second condenser aperture 240 can be used to limit the illuminated area in the specimen plane 252.

The TEM 200 further includes an objective module 250 downstream of the condenser module 230. As shown in FIG. 2, the objective module 250 includes a first objective lens 254 positioned upstream of the specimen plane 252, a second objective lens 256 positioned downstream of the specimen plane 252, and an intermediate lens 258 positioned downstream of the second objective lens 256. The objective module 250 additionally or alternatively may be referred to as an objective optics assembly 250.

The first objective lens 254 collimates the electron beam 202, while the second objective lens 256 focuses the electron beam 202 at a back focal plane 260. The objective module 250 also includes an objective aperture 262 positioned at the back focal plane 260. The intermediate lens 258 images the back focal plane 260 onto a diffraction plane 270 at which a diffraction pattern 272 formed by the electron beam 202 may be recorded.

The TEM 200 additionally includes a detector 280 positioned at a detector plane 282 for recording the diffraction pattern. In the example of FIG. 2, the detector plane 282 is coplanar with the diffraction plane 270.

As shown in FIG. 2, when the electron beam 202 encounters the specimen in the specimen plane 252, the electron beam is modified by the specimen to yield a modulated electron beam 202' downstream of the specimen plane 252. In particular, the modulated electron beam 202' can include a portion of the electron beam 202 that is modified via interaction with the specimen, such as via scattering interactions, such that the modulated electron beam 202' contains information regarding structure of the specimen. The modulated electron beam 202' also can include a portion of the electron beam 202 that passes through the specimen substantially unaltered. In FIG. 2, the portion of the electron beam 202 and/or of the modulated electron beam 202' that is modulated via interaction with the specimen is illustrated in dashed lines, while the portion of the electron beam 202 and/or of the modulated electron beam 202' that is unaffected by the specimen is shown in solid lines.

In any plane downstream of the specimen plane 252, the modulated electron beam 202' may be described as having a modulated beam pattern. For example, In the example of FIG. 2, the rays of the modulated electron beam 202' are focused at the diffraction plane 270 such that the modulated beam pattern in the diffraction plane 270 includes and/or is the diffraction pattern 272, which in the example of FIG. 2 may take the form of spaced-apart beam spots. In other planes, the modulated beam patter may exhibit other shapes and/or forms, such as rings, discs, etc. In this manner, the modulated beam pattern may be described as representing a cross-section of the modulated electron beam 202' in a plane of interest.

In the present disclosure, the term "diffraction plane" is intended to refer to a plane in which a portion of the electron beam 202 passing through the specimen is focused by one or more optical elements downstream of the specimen plane 252. In general, the TEM 200 may include a plurality of such planes that are conjugate with one another. With reference to FIG. 2, for example, while the diffraction plane 270 is positioned downstream of the back focal plane 260, the electron beam 202 and the modulated electron beam 202' also are focused in the back focal plane 260. Accordingly, the back focal plane 260 also may be described as representing another diffraction plane of the TEM 200. In general, positioning the detector 280 at any such diffraction plane can be used to record the diffraction pattern generated by the specimen. In practice, however, it may be beneficial to position the detector 280 at a diffraction plane (such as the diffraction plane 270) at which the diffraction pattern is magnified relative to that in the back focal plane 260.

As introduced above, the TEM 200 includes a beam deflector 216 that may be used to selectively divert the electron beam 202 away from the specimen. As shown in FIG. 2, the beam deflector 216 is positioned at a deflector plane 208 that is positioned within the source module 210. This is not required, however, and it also is within the scope of the present disclosure that the deflector plane 208 may be located at a different location, such as a location apart from (e.g., downstream of) the source module 210, and the deflector plane 208 need not be the same or proximate to the crossover plane 206.

In some examples, the beam deflector 216 may be used to direct the electron beam 202 away from the specimen until an image (e.g., a diffraction pattern) is to be recorded in order to protect the specimen from damage by the electron beam 202. In this manner, the beam deflector 216 may be regarded as representing a shutter mechanism that can be used to at least partially define an exposure time during which the electron beam 202 is directed to the specimen.

Additionally, or alternatively, the beam deflector 216 may be configured to direct the electron beam 202 to the specimen in the form of short pulses such that the specimen is excited by the electron beam 202 for a precisely controlled interval of time. In this manner, the beam deflector 216 can enable a time-resolved analysis of the specimen in which the duration of the electron beam pulses may be varied to study the effect of varying degrees of specimen excitation. As more specific examples, the TEM 200 may be used to perform pump-probe microscopy studies that harness nonlinear optical imaging techniques for specimen characterization and analysis. Additionally, or alternatively, use of the beam deflector 216 can enable a user to vary a balance between time resolution (generally corresponding to shorter beam pulses) and signal strength (generally corresponding to longer beam pulses).

As shown in FIG. 2, the beam deflector 216 generally may be configured to divert the electron beam 202 to yield a deflected beam 203 downstream of the beam deflector 216, which in turn may be blocked by a blanking structure. In the example of FIG. 2, the blanking structure is the source module aperture 218. This is not required of all examples, however, and it also is within the scope of the present disclosure that the beam deflector 216 can selectively direct the deflected beam 203 toward any other suitable structure, such as the first condenser aperture 236 or the second condenser aperture 240.

The beam deflector 216 can assume any of a variety of forms. For example, the beam deflector 216 can include and/or be an electrostatic beam deflector in which a voltage is selectively applied to opposed electrodes to selectively divert the electron beam 202 to the blanking structure. As a more specific example, an electrostatic beam deflector can include rod-shaped electrodes positioned on either side of the optical axis 204, one of which is maintained at a ground potential and the other of which is selectively brought to a deflection potential. When a substantial potential difference is introduced between the electrodes, the resultant electric field can divert the trajectory of the electron beam 202 toward and/or to the blanking structure.

Additionally, or alternatively, the beam deflector 216 can include and/or be a magnetic beam deflector in which a magnetic field is selectively generated (e.g., via an electric current) to deflect the electron beam 202.

The use of an electrostatic beam deflector may enable faster switching operation between the blanked and unblanked states relative to a magnetic beam deflector. This in turn may be particularly beneficial in the context of time-resolved studies with exposure durations on the order of nanoseconds. For example, in the case of a magnetic beam deflector, the beam deflection may be accomplished by generating transverse magnetic fields with a magnetic material. The slow settling time of magnetic domains in the magnetic material, however, can limit the speed at which a magnetic beam deflector can transition between the blanked and unblanked states. Additionally, such magnetic materials can be susceptible to magnetic hysteresis effects that introduce remnant magnetic fields that are variable for each blank-unblank cycle. By contrast, an electrostatic beam deflector can be operated between the blanked and unblanked states at high speed relative to a magnetic beam deflector and is not susceptible to magnetic hysteresis effects.

The beam deflector 216 may be incorporated into the TEM 200 in any suitable manner. For example, one or more components of the beam deflector 216 may be coupled to and/or supported by a structure found in conventional TEM systems, such as a variable aperture mechanism. In other examples, the TEM 200 can include a dedicated structure for maintaining the beam deflector 216 in position relative to the optical axis 204.

In the present disclosure, two or more planes within and/or associated with a CPM system (such as the TEM 200) may be described as being conjugate to one another when each point in one such plane is imaged onto a corresponding point in another such plane. For example, with reference to FIG. 2, any of the deflector plane 208, the back focal plane 260, and the diffraction plane 270 may be described as being conjugate to one another.

As described in more detail below, configuring the TEM 200 such that the deflector plane 208 is conjugate with the diffraction plane 270 and/or with the detector plane 282 can yield benefits in the performance of the beam deflector 216. In particular, in such a configuration, the beam deflector 216 may cause tilting of the electron beam 202 in a pivot plane that is conjugate to the detector plane 282. Thus, in such a configuration, the stationary point about which the electron beam 202 is deflected by the beam deflector 216 appears stationary in the detector plane 282 as well as the beam deflector 216 transitions between the blanked and unblanked states. In the present disclosure, such a configuration generally may be referred to as a conjugate blanking configuration.

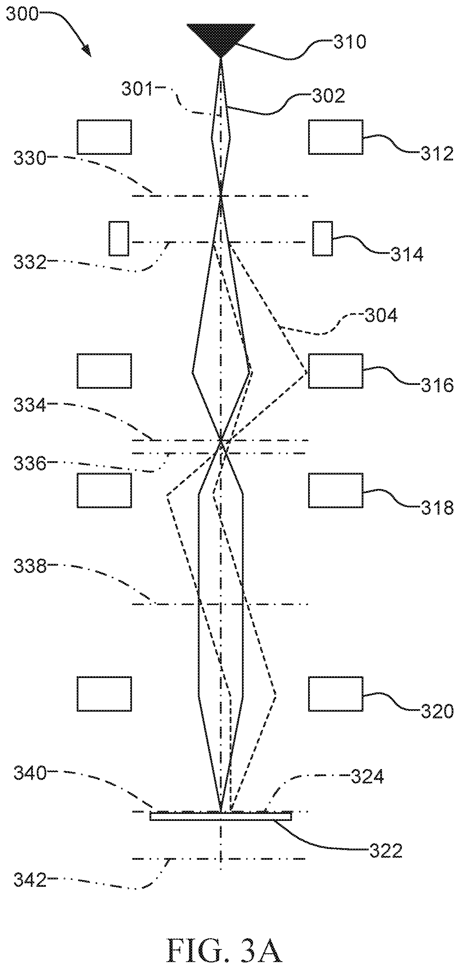

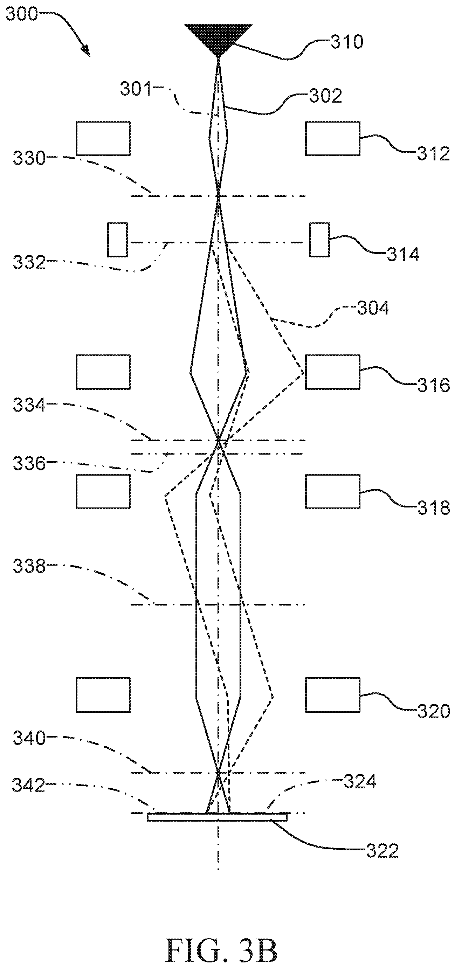

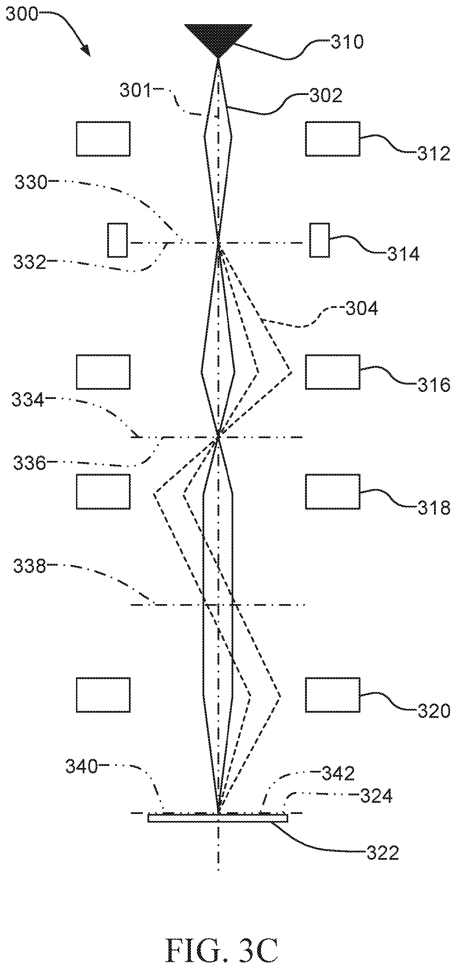

FIGS. 3A-3C are schematic representations of the paths of rays of an electron beam 302 that traverses a TEM 300, which may share any suitable components, attributes, etc. with the TEM 200 of FIG. 2 and/or the CPM system 100 of FIG. 1. As described in more detail below, FIGS. 3A-3C illustrate an example of a sequence of operations by which the TEM 300 may be brought to a conjugate blanking configuration according to the present disclosure. As described in more detail below, FIG. 3A may be described as representing an initial configuration of the TEM 300, FIG. 3B may be described as representing an intermediate configuration of the TEM 300, and FIG. 3C may be described as representing a conjugate blanking configuration of the TEM 300. It is to be understood, however, that the configurations illustrated in FIGS. 3A-3C represent a non-exclusive example of a sequence of operations according to the present disclosure. For example, and as discussed in more detail below, another sequence of operations according to the present disclosure may begin with an initial configuration other than that depicted by FIG. 3A.

As shown in FIGS. 3A-3C, the TEM 300 includes an electron source 310 that emits the electron beam 302 along an optical axis 301, a first optical element 312 (e.g., a lens), and a beam deflector 314 positioned at a deflector plane 332 downstream of the first optical element 312. The TEM 300 additionally includes a second optical element 316 (e.g., a lens) downstream of the deflector plane 332 and a third optical element 318 (e.g., a lens) downstream of the second optical element 316. The electron beam 302 is incident upon a specimen positioned at a specimen plane 338, and a detector 322 is positioned at a detector plane 324 to record a modulated beam pattern (e.g., a diffraction pattern) formed by the electron beam 302 downstream of the specimen plane 338. A fourth optical element 320 (e.g., a lens) is positioned between the specimen plane 338 and the detector plane 324, such as to focus the electron beam 302 to form a diffraction pattern in a diffraction plane 340.

For simplicity, FIGS. 3A-3C illustrate trajectories of the electron beam 302 as shaped and/or guided by the optical elements of the TEM 300 without depicting the diffraction effects that may be introduced when specimen is positioned at the specimen plane 338. It is to be understood, however, that the characteristics and properties described herein with reference to FIGS. 3A-3C also may pertain to examples in which the electron beam 302 is diffracted by a specimen positioned at the specimen plane 338. Accordingly, descriptions of methods and/or procedures that are presented with reference to FIGS. 3A-3C may pertain to examples in which the specimen is positioned at the specimen plane 338 as well as to examples in which the specimen is removed from the specimen plane 338.

Similarly, while the diffraction plane 340 corresponds to a plane in which the electron beam 302 forms a diffraction pattern when diffracted by a specimen, this plane may be referred to as the diffraction plane 340 even in examples in which the electron beam 302 is not diffracted by the specimen. For example, and as discussed in more detail below, the diffraction plane 340 can refer to a plane in which a diffracted or undiffracted electron beam exhibits a beam crossover and/or is focused. Stated differently, the diffraction plane 340 refers to a plane in which a diffraction pattern is or would be formed when the electron beam 302 is diffracted by the specimen, regardless of whether or not the specimen is present. Accordingly, references herein to the diffraction plane 340 are not intended to imply that the corresponding electron beam was diffracted by a specimen upstream of the diffraction plane 340.

The first optical element 312, the second optical element 316, the third optical element 318, and/or the fourth optical element 320 each can include and/or be any suitable optical element(s), such as optical elements introduced above with reference to FIGS. 1-2. For example, the first optical element 312 may represent, include, and/or be one or more lenses of a source module, such as the gun lens 214 of FIG. 2.

Additionally, or alternatively, the second optical element 316 may represent, include, and/or be one or more lenses of a condenser module, such as the first condenser lens 232, the second condenser lens 234, the third condenser lens 238, and/or the fourth condenser lens 242 of FIG. 2.

Additionally, or alternatively, the third optical element 318 and the fourth optical element 320 each may represent, include, and/or be one or more lenses of an objective module, such as the first objective lens 254, the second objective lens 256, and/or the intermediate lens 258 of FIG. 2. As a more specific example, the third optical element 318 can include and/or be an objective lens element such as the first objective lens 254 of FIG. 2, while the fourth optical element 320 can include and/or be another objective lens element such as the second objective lens 256 of FIG. 2. In some examples, the diffraction plane 340 can be a back focal plane associated with the fourth optical element 320 or can be a plane that is conjugate to such a back focal plane.

FIGS. 3A-3C additionally illustrates in dashed lines the path of rays of a partially deflected beam 304, which represents a portion of the electron beam 302 that is partially diverted away from the optical axis 301 and/or the specimen by the beam deflector 314. In particular, although a beam that is fully deflected by the beam deflector 314 in the blanked state (e.g., the deflected beam 203 of FIG. 2) does not reach the specimen plane 338 or the diffraction plane 340, the beam deflector 314 cannot produce such a fully deflected beam instantaneously. Instead, as the beam deflector 314 transitions toward the blanked state, the beam deflector 314 produces a continuous series of partially deflected beams that reach the specimen plane 338 and/or the diffraction plane 340 along trajectories similar to those shown in dashed lines in FIGS. 3A-3C.

The partially deflected beams 304 of any of FIGS. 3A-3C may be understood as representing any such beam trajectory associated with an intermediate state of the beam deflector 314 defined between the unblanked state and the fully blanked state. As used herein, the intermediate state of the beam deflector 314 additionally or alternatively may be referred to a partially blanked state and/or a partially deflected state. In this manner, the beam deflector 314 may be described as transitioning among a plurality (e.g., a continuous plurality) of intermediate states and/or partially deflected states as the beam deflector 314 transitions between the unblanked state and the fully blanked state. In general, each partially blanked state may produce a corresponding trajectory of the electron beam 304 downstream of the beam deflector 314 and/or a corresponding beam pattern at the detector plane 324. The electron beam 302 shown in solid lines in FIGS. 3A-3C also may be referred to as an unblanked electron beam 302 and/or an undeflected electron beam 302.

In this manner, terms such as "partially deflected" and/or "partially blanked," as used herein to characterize a state and/or configuration of the electron beam 302 and/or of the beam deflector 314, do not necessarily refer to a state and/or configuration to which elements of the TEM 300 are deliberately brought and/or maintained. Rather, such terms generally may be understood as referring to any of various intermediate states and/or configurations that generally are realized only momentarily during operative use of the TEM, but which still may be illustrative in describing operation of the beam deflector 314 between the blanked state and the unblanked state.

FIG. 3A illustrates a configuration of the TEM 300 in which operating the beam deflector 314 can cause lateral motion of the electron beam 302 in the diffraction plane 340. FIG. 3A may be described as representing an example of an initial configuration of the TEM 300; e.g., prior to bringing the TEM to the conjugate blanking configuration. In particular, in the example of FIG. 3A, the diffraction plane 340 is coplanar with the detector plane 324 such that the diffraction pattern formed by the electron beam 302 is focused onto the detector 322. As may be seen comparing the trajectories of the undeflected electron beam 302 and of the partially deflected beam 304 at the detector plane 324, however, operating the beam deflector 314 between the blanked and unblanked states causes the focused spot of the electron beam to move within the detector plane 324. As a result, when the beam deflector 314 transitions from the unblanked state to the blanked state, visible streaks can appear in the diffraction pattern recorded by the detector 322 before the electron beam 302 is fully blanked.

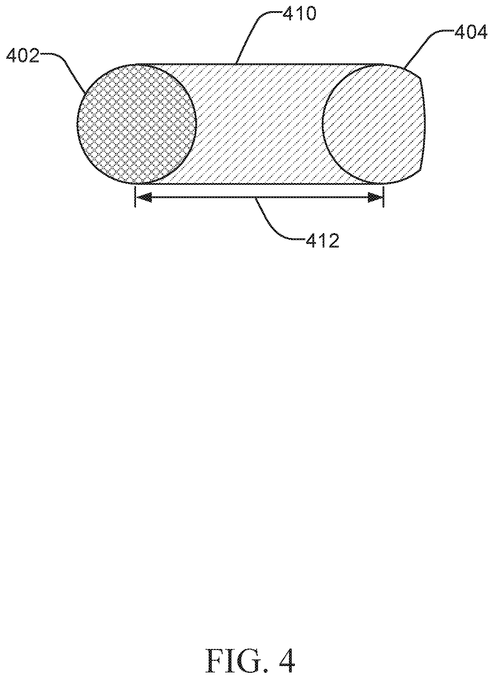

FIG. 4 illustrates an example of a streak 410 that may be formed in a diffraction plane (e.g., the diffraction plane 340) and/or recorded by a detector (e.g., the detector 322) as a beam deflector (e.g., the beam deflector 314) transitions from an unblanked state to a fully blanked state. In particular, FIG. 4 illustrates an unblanked beam spot 402 and a partially blanked beam spot 404 connected by the streak 410 with a streak length 412. The unblanked beam spot 402 and the partially blanked beam spot 404 may be described as corresponding to spots formed by the undeflected electron beam 302 and the partially deflected beam 304 of FIG. 3A, respectively, as recorded by the detector 322. The streak 410 connecting the unblanked beam spot 402 and the partially blanked beam spot 404 may be described as representing the path traced by the focused electron beam in the detector plane as the beam deflector transitions toward the fully blanked state.

While FIG. 4 illustrates an example of a streak that may be associated with a focused beam spot in a diffraction pattern, it is to be understood that such a description similarly applies to features of diffraction patterns and/or of focused and/or unfocused electron beams such as rings, discs, etc. In such cases, the streaking additionally or alternatively may appear as a blurring and/or elongation of such features.

As discussed above, the presence of such streaks 410 in a recorded diffraction pattern may be particularly undesirable in applications such as nanosecond-scale time-resolved pump-probe studies, in which the time interval needed to transition the beam deflector between the unblanked state and the fully blanked state is a significant proportion of the total exposure time. By contrast, the conjugate blanking configuration of the TEM described herein can yield diffracted beam spots that are substantially stationary in the detector plane as the beam deflector transitions between the unblanked state and the fully blanked state. As a result, the form and/or details of the diffraction pattern may remain correspondingly substantially unmodified by the process of blanking or unblanking the electron beam.

As used herein, the term "substantially stationary," as used to describe and/or characterize a beam spot or pattern in a given plane (e.g., in a diffraction plane and/or a detector plane), can refer to a beam spot or pattern that remains fixed in position relative to the plane and/or to a beam spot or pattern that moves only slightly relative to the plane. For example, a beam spot or pattern may be described as being "substantially stationary" during a process in which an orientation and/or shape of the beam spot or pattern shifts, such as via a change in size and/or rotational orientation about a point that remains within the beam spot or pattern. Additionally, or alternatively, a beam spot or pattern may be described as being "substantially stationary" during a process in which a central point (e.g., a centroid) of the beam spot or pattern shifts by a proportion of a maximum linear dimension of the beam spot or pattern that is less than 50% of the maximum linear dimension, less than 40% of the maximum linear dimension, less than 30% of the maximum linear dimension, less than 20% of the maximum linear dimension, and/or less than 10% of the maximum linear dimension.

Returning to FIG. 3A, the lateral offset of the focused spots of the undeflected electron beam 302 and of the partially deflected beam 304 may be described as resulting from the feature that the deflector plane 332 is axially separated from a crossover plane 330 in which the electron beam 302 is focused (e.g., by the first optical element 312). The crossover plane 330 may be described as representing a first crossover plane 330, with the undeflected electron beam 302 and the partially deflected beam 304 additionally being focused to crossover points in a second crossover plane 334.

In the present disclosure, the term "crossover plane" may refer to any plane in which the various rays characterizing a given beam (e.g., the electron beam 304) are focused to a point and thus "cross over" one another. Accordingly, with reference to FIG. 3A, the diffraction plane 340 also may be described as a third crossover plane 340. It also is within the scope of the present disclosure that a given beam (e.g., an electron beam) need not be focused exactly to a point in a crossover plane, and that a crossover plane additionally or alternatively may refer to a plane in which a beam diameter reaches a nonzero local minimum (e.g., due to optical aberrations).

In the example of FIG. 3A, the third crossover plane 340 is coplanar with the detector plane 324. Accordingly, FIG. 3A may be described as depicting an example of an initial configuration in which the electron beam 302 is focused onto the detector 322. This is not required of all examples, however. For example, it additionally is within the scope of the present disclosure that the TEM 300 can be brought to the conjugate blanking configuration of FIG. 3C from an initial configuration other than that shown in FIG. 3A, such as an initial configuration in which the third crossover plane 340 is positioned upstream of the detector plane 324 or downstream of the detector plane 324.

The configurations shown in FIGS. 3A-3C also may be described with reference to the series of planes that are conjugate to the deflector plane 332. For example, as shown in FIG. 3A, the illustrated configuration exhibits a first conjugate deflector plane 336 and a second conjugate deflector plane 342 that each are conjugate to the deflector plane 332.

FIG. 3C illustrates the TEM 300 of in a conjugate blanking configuration, while FIG. 3B illustrates an intermediate configuration of the TEM 300 that may be reached during an example of a method of bringing the TEM 300 to the conjugate blanking configuration of FIG. 3C. In particular, relative to the configuration of FIG. 3A, FIG. 3B illustrates a configuration in which the fourth optical element 320 has been adjusted to move the second conjugate deflector plane 342 into axial alignment with the detector plane 324. For example, the fourth optical element 320 may include and/or be an objective lens element (e.g., the second objective lens 256 of FIG. 2), and transitioning the TEM 300 from the configuration of FIG. 3A to the configuration of FIG. 3B may correspond to adjusting the objective lens element to shorten a focal length thereof.

As shown in FIG. 3B, moving the second conjugate deflector plane 342 into axial alignment with the detector plane 324 can have the effect of shifting the diffraction plane 340 away from the detector plane 324, such as to an axial position upstream of the detector plane 324. Thus, in this example, bringing the TEM 300 to the intermediate configuration of FIG 3B may be described as having the effect of moving a focal plane of the electron beam 302 away from the detector plane 324, thereby defocusing the electron beam 302 in the detector plane 324. This is not required of all examples, however, and it also is within the scope of the present disclosure that bringing the TEM 300 to the intermediate configuration can include bringing the diffraction plane 340 closer to the detector plane 324.

As used herein, the term "axial alignment," as used to describe and/or characterized two or more entities (e.g., components, points, planes, etc.), refers to a configuration in which the entities are located at a common axial location (e.g., relative to and/or along the optical axis 301).

As shown in FIG. 3B, the intermediate configuration of the TEM 300 corresponds to a configuration in which the undeflected electron beam 302 and the partially deflected beam 304 form overlapping spots in the detector plane 324. In this configuration, the detector plane 324 is conjugate to the deflector plane 332. Because the detector plane 324 is axially separated from the diffraction plane 340, the spots corresponding to the undeflected electron beam 302 and the partially deflected beam 304 may be described as being unfocused spots. Because the spots corresponding to the undeflected electron beam 302 and the partially deflected beam 304 are overlapping in the detector plane 324, the location of this beam spot can remain substantially stationary as the beam deflector 314 transitions between the unblanked state and the fully blanked state.

Transitioning the TEM 300 from the intermediate configuration of FIG. 3B to the conjugate blanking configuration of FIG. 3C can correspond to focusing the undeflected electron beam 302 and the partially deflected beam 304 in the detector plane 324 while maintaining these focused spots in an overlapping configuration. In particular, transitioning the TEM 300 to the configuration of FIG. 3C may be performed by adjusting the first optical element 312 to bring the first crossover plane 330 into axial alignment with the deflector plane 332. As a more specific example, the first optical element 312 can include and/or be the gun lens 214 of FIG. 2, and transitioning the TEM 300 to the configuration of FIG. 3C may be performed by increasing a focal length of the first optical element 312. In such examples, because the setting (e.g., excitation and/or focal length) of the gun lens at least partially determines the axial position of the first crossover plane 330, the TEM 300 may be constrained to being used at such a gun lens setting during subsequent specimen analysis. It is to be understood, however, that various other aspects of the electron beam 302 may be adjusted while the TEM 300 remains in the conjugate blanking configuration. For example, with the TEM 300 in the conjugate blanking configuration, the width of the electron beam at the specimen plane 338 can be adjusted, such as to change the illuminated area of the specimen at the specimen plane 338. Such adjustment can be performed, for example, via adjustment of optical elements downstream of the deflector plane 332 and upstream of the specimen plane 338, such as the second optical element 316 and/or the third optical element 318. As another example, with the TEM 300 in the conjugate blanking configuration, a magnification of the diffraction pattern formed by the electron beam 302 at the detector plane 324 can be adjusted, such as via adjustment of optical elements downstream of the specimen plane 338 (e.g., the fourth optical element 320).

In the configuration of FIG. 3C, the deflector plane 332 is conjugate to each of the diffraction plane 340 and the detector plane 324 as well as to the second crossover plane 334. As a result, when the beam deflector 314 transitions from the unblanked state toward the fully blanked state, the electron beam 302 remains focused to one or more locations (e.g., a diffraction pattern) that remain substantially stationary in the detector plane 324. When the beam deflector 314 reaches the fully blanked state, the electron beam 302 ceases to reach the detector plane 324, and the diffraction pattern dims and/or vanishes substantially without exhibiting blurring and/or steaking.

FIGS. 3A-3C illustrate a sequence of operations by which the TEM 300 is brought to the conjugate blanking configuration (FIG. 3C) from an initial condition in which the electron beam 302 is focused at the detector plane 324 (FIG. 3A). In other examples, a similar sequence of operations can be used to bring the TEM 300 to the conjugate blanking configuration of FIG. 3C when the electron beam 302 is not initially focused at the detector plane 324.

For example, the electron beam 302 may be initially underfocused such that the third crossover plane 340 is initially positioned downstream of the detector plane 324. In such an example, transitioning the TEM 300 to the conjugate blanking configuration may include first transitioning the TEM 300 to the intermediate configuration of FIG. 3B by bringing the second conjugate deflector plane 342 into axial alignment with the detector plane 324. Similar to the example of FIGS. 3A-3B, this may be accomplished by shortening a focal length of the fourth optical element 320 to move the second conjugate deflector plane 342 in the upstream direction. In some examples, this can have the effect of moving the third crossover plane 340 upstream through and past the axial position of the detector plane 324 such that the electron beam 302 sequentially increases and decreases in focus at the detector plane 324 as the TEM 300 transitions to the intermediate configuration.

As another example, the electron beam 302 may be initially overfocused such that the third crossover plane 340 is initially positioned upstream of the detector plane 324. In such an example, transitioning the TEM 300 to the conjugate blanking configuration again may include first transitioning the TEM 300 to the intermediate configuration of FIG. 3B by bringing the second conjugate deflector plane 342 into axial alignment with the detector plane 324. In this example, this may be accomplished by increasing a focal length of the fourth optical element 320 to move the second conjugate deflector plane 342 in the downstream direction.

A configuration in which the electron beam 302 initially overfocused, however, can correspond to a configuration in which the second conjugate deflector plane 342 is initially positioned upstream or downstream of the detector plane 324. Accordingly, bringing the second conjugate deflector plane 342 into axial alignment with the detector plane 324 may can have the result of increasing and/or decreasing a degree of focus of the electron beam 302 at the detector plane 324 while the TEM 300 transitions to the intermediate configuration.

In general, when the TEM 300 is initially in a configuration in which the electron beam 302 is not focused at the detector plane 324, it may be unknown whether the electron beam 302 is underfocused or overfocused relative to the detector plane 324. Accordingly, it may be unknown whether the second conjugate deflector plane 342 needs to be moved in the upstream direction or the downstream direction in order to bring the second conjugate deflector plane 342 into axial alignment with the detector plane 324.

Transitioning the TEM 300 to the intermediate configuration from an arbitrary initial configuration thus may include iteratively shifting the second conjugate deflector plane 342 in the upstream direction or the downstream direction and measuring an effect of such a shift. For example, because the intermediate configuration corresponds to a configuration in which the undeflected electron beam 302 and the partially deflected beam 304 are overlapping in the detector plane 324, the intermediate configuration may be reached by iteratively shortening and/or minimizing a streak length between the undeflected electron beam 302 and the partially deflected beam 304 during operation of the beam deflector 314.

FIGS. 3A-3C depict a sequence of operations by which the TEM 300 is brought to the conjugate blanking configuration by first bringing the second conjugate deflector plane 342 into axial alignment with the detector plane 324 and subsequently bringing the first crossover plane 330 into axial alignment with the deflector plane 332. Performing such adjustments in this sequence can ensure that the detector plane 324 remains conjugate to the deflector plane 332 while the electron beam 302 is focused onto the detector plane 324 with the first optical assembly 312.

This sequence is not required of all examples, however. For example, the TEM 300 also can be brought to the conjugate blanking configuration by iteratively adjusting an upstream optical element positioned upstream of the deflector plane 332 (e.g., the first optical element 312) to a selected setting, focusing the electron beam 302 onto the detector plane 324 with a downstream optical element positioned downstream of the deflector plane 332 (e.g., the fourth optical element 320), and measuring a streak length between the undeflected electron beam 302 and the partially deflected beam 304. In some examples, bringing the upstream optical element to the selected setting can include adjusting a focal length of the upstream optical element to adjust a defocus of the electron beam 302 at the deflector plane 324. Repeating these steps with different selected settings (e.g., focal lengths) of the upstream optical element thus allows for a comparison between the streak lengths corresponding to such settings. The differences (e.g., sign and magnitude) between successively measured streak lengths can then be used to iteratively select the subsequent settings of the upstream optical element until the measured streak lengths are minimized with the electron beam 302 focused at the detector plane 324, at which point the TEM 300 may be understood as being in the conjugate blanking configuration. Such an iterative process may be performed manually and/or at least partially automatically.

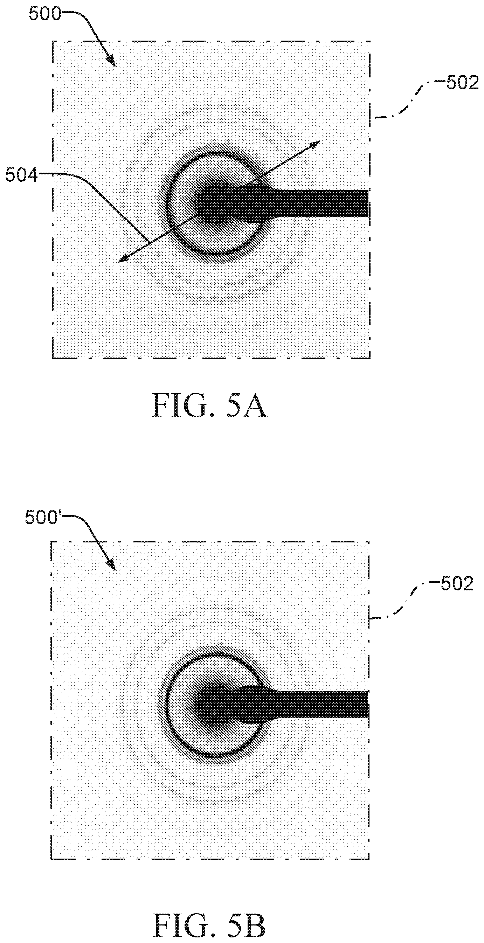

FIGS. 5A-5B represent examples of diffraction patterns of a gold specimen recorded before (FIG. 5A) and after (FIG. 5B) bringing a TEM to a conjugate blanking configuration. That is, FIG. 5A may be described as representing an example of a diffraction pattern 500 as recorded in a diffraction plane 502 with a TEM in an initial configuration similar to that of FIG. 3A, while FIG. 5B may be described as representing an example of a corresponding diffraction pattern 500' as recorded with the same TEM in a conjugate blanking configuration as shown in FIG. 3C.

In each of FIGS. 5A-5B, the diffraction pattern is recorded with a detector (e.g., the detector 322) during an exposure that is terminated by transitioning a beam deflector (e.g., the beam deflector 314) to a fully blanked state. As shown in FIGS. 5A-5B, the diffraction pattern 500 obtained with the TEM not in the conjugate blanking configuration exhibits significantly more blurring and less well-resolved features than the corresponding diffraction pattern 500' obtained with the TEM in the conjugate blanking configuration. In particular, comparing FIGS. 5A-5B, it may be seen that the diffraction pattern 500 exhibits blurring along a blurring direction 504, thus rendering the radius of each feature of the diffraction pattern 500 more difficult to measure precisely than in the example of the diffraction pattern 500'.

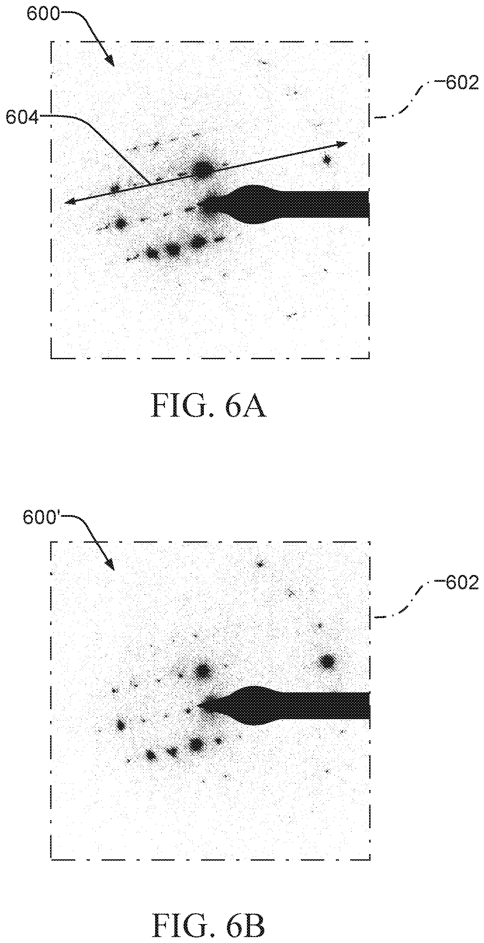

FIGS. 6A-6B represent additional examples of diffraction patterns of single crystalline gallium nitride recorded before (FIG. 6A) and after (FIG. 6B) bringing a TEM to a conjugate blanking configuration. That is, FIG. 6A may be described as representing an example of a diffraction pattern 600 as recorded in a diffraction plane 602 with a TEM in an initial configuration similar to that of FIG. 3A, while FIG. 6B may be described as representing an example of a corresponding diffraction pattern 600' as recorded with the same TEM in a conjugate blanking configuration as shown in FIG. 3C. FIGS. 5A-5B illustrate examples of diffraction patterns that include a series of diffraction rings, while FIGS. 6A-6B illustrate examples of diffraction patterns that include spaced apart and localized diffraction spots.

In each of FIGS. 6A-6B, the diffraction pattern is recorded with a detector (e.g., the detector 322) during an exposure that is terminated by transitioning a beam deflector (e.g., the beam deflector 314) to a fully blanked state. As shown in FIGS. 6A-6B, the diffraction pattern 600 obtained with the TEM not in the conjugate blanking configuration exhibits significantly more blurring and less well-resolved features than the corresponding diffraction pattern 600' obtained with the TEM in the conjugate blanking configuration. In particular, comparing FIGS. 6A-6B, it may be seen that the diffraction pattern 600 exhibits blurring along a blurring direction 604, thus rendering the position of each feature of the diffraction pattern 600 more difficult to measure precisely than in the example of the diffraction pattern 600'.

### Exemplary Methods

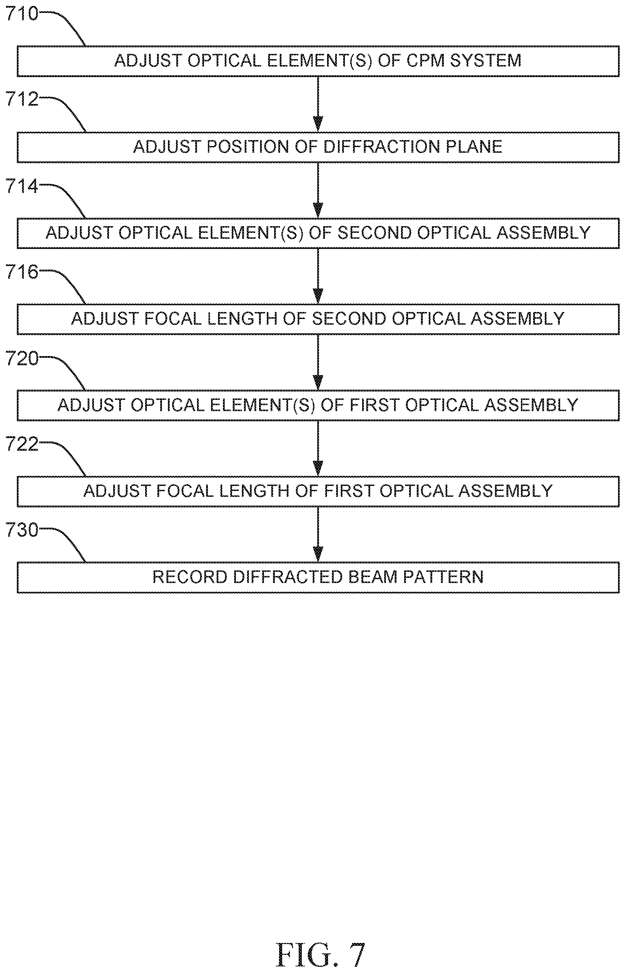

FIG. 7 is a flowchart depicting examples of a method 700 of operating a CPM system that includes a beam deflector positioned at a deflector plane and that is configured to direct a charged particle beam to a specimen to produce a diffracted beam pattern at a diffraction plane. The method 700 may be performed in conjunction with any suitable CPM system. For example, the CPM system can include and/or be the CPM system 100 of FIG. 1, the TEM 200 of FIG. 2, and/or the TEM 300 of FIGS. 3A-3C, and/or any suitable portions thereof. The CPM system additionally or alternatively can include any suitable features and/or characteristics not specifically described herein.

Any of the system components discussed and/or described herein with reference to the method 700 may be understood as representing and/or referring to similarly named components of the CPM system 100, the TEM 200 and/or the TEM 300 and/or to functional equivalents thereof. For example, the beam deflector described herein with reference to the method 700 can represent the deflector 112 of FIG. 1, the beam deflector 216 of FIG. 2, and/or the beam deflector 314 of FIGS. 3A-3C. In this manner, the method 700 may be understood in the context of the above descriptions of the CPM system 100, the TEM 200, and/or the TEM 300, and vice versa. This is not required, however, and it additionally is within the scope of the present disclosure that the method 700 may be performed in conjunction with any suitable components.

As shown in FIG. 7, the method 700 includes adjusting, at 710, one or more optical elements of the CPM system such that the deflector plane is conjugate to the diffraction plane. The method 700 additionally includes recording, at 730, the diffracted beam pattern with a detector positioned at the diffraction plane.

As described herein, the adjusting the optical element(s) at 710 can include adjusting, at 712, a position (e.g., an axial position) of the diffraction plane to bring the diffraction plane into axial alignment with the detector. For example, the CPM system can include a first optical assembly positioned upstream of the deflector plane and a second optical assembly positioned downstream of the deflector plane, and the adjusting the position of the diffraction plane at 712 can include adjusting, at 714, one or more optical elements of the second optical assembly. In particular, the adjusting the position of the diffraction plane at 712 can include the adjusting the optical element(s) of the second optical assembly at 714 to shift the position of diffraction plane in an axial direction (e.g., along the optical axis 301 of FIGS. 3A-3C). With reference to the TEM 200 of FIG. 2, for example, the first optical assembly can include one or more components of the source module 210 upstream of the beam deflector 216, and/or the second optical assembly can include one or more components of the condenser module 230 and/or of the objective module 250. Accordingly, as a more specific example, the adjusting the optical element(s) of the second optical assembly at 714 can include adjusting the second objective lens 256 and/or the intermediate lens 258 to shift the axial location of the diffraction plane, as discussed above.

As additional (or alternative) examples, and with reference to the CPM system 300 of FIGS. 3A-3C, the first optical assembly can include and/or be the first optical element 312, and the second optical assembly can include and/or be any of the second optical element 316, the third optical element 318, and/or the fourth optical element 320. Accordingly, as a more specific example, the adjusting the optical element(s) of the second optical assembly at 714 can include adjusting the fourth optical element 320 to shift the axial location of the diffraction plane, as discussed above.

As discussed above, the diffraction plane may refer to a plane in which a diffraction pattern is formed when the charged particle beam passes through the specimen, and this plane still may be referred to as the diffraction plane even when the specimen and/or diffraction pattern are not present.

In some examples, and as shown in FIG. 7, the adjusting the optical element(s) of the second optical assembly at 714 can include adjusting, at 716, a focal length of the element(s) of the second optical assembly. For example, the second optical assembly can include an objective lens, such as the second objective lens 256 and/or the intermediate lens 258 of FIG. 2, and the adjusting the position of the diffraction plane at 712 can include adjusting a focal length of the objective lens to bring the diffraction plane into axial alignment with the detector.

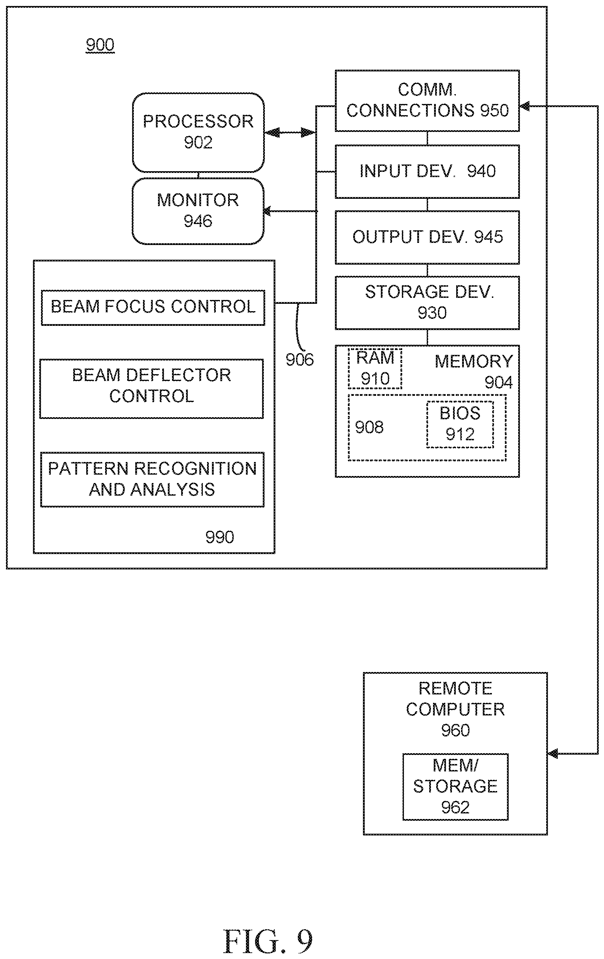

As shown in FIG. 7, the adjusting the optical element(s) at 710 additionally can include adjusting, at 720, one or more optical elements of the first optical assembly to bring a crossover plane of the charged particle beam into axial alignment with the detector. In particular, in some examples, and as shown in FIG. 9, the adjusting the optical element(s) of the first optical assembly at 720 includes adjusting, at 722, a focal length associated with the first optical assembly.

As a more specific example, and with reference to the TEM 200 of FIG. 2, the adjusting the optical element(s) of the first optical assembly at 720 can include adjusting the gun lens 214, such as to vary a focal length of the gun lens 214. Additionally, or alternatively, and with reference to the CPM system 300 of FIGS. 3A-3C, the adjusting the optical element(s) of the first optical assembly at 720 can include adjusting the first optical element 312, such as by adjusting a focal length thereof.

In some examples, the focal length of the first optical assembly adjusted during the adjusting at 722 may be referred to as a first focal length and the focal length of the second optical assembly adjusted during the adjusting at 716 may be referred to as a second focal length.

The adjusting the first focal length at 722 and/or the adjusting the second focal length at 716 each may be performed in any suitable manner. For example, the optical elements adjusted during the adjusting the optical element(s) of the first optical assembly at 720 and/or the adjusting the optical element(s) of the second optical assembly at 714 may include and/or be electro-optical lens elements, and the adjusting the focal length(s) at 716 and/or the adjusting the focal length(s) at 722 may include adjusting an excitation voltage that is applied to such lens elements. In some examples, this may be performed at least in part with a controller, such as the controller 150 of FIG. 1.

The adjusting the optical element(s) of the first optical assembly at 720 and/or the adjusting the first focal length at 722 can include adjusting such that a crossover plane of the charged particle beam (e.g., the first crossover plane 330 of FIGS. 3A-3C) is axially aligned with the deflector plane. Additionally, or alternatively, the adjusting the optical elements(s) of the second optical assembly at 714 and/or the adjusting the second focal length at 716 can include adjusting such that a conjugate deflector plane (e.g., the second conjugate deflector plane 342 of FIGS. 3A-3C) is axially aligned with the detector plane as described herein.

In some examples, the adjusting the optical element(s) of the first optical assembly at 720 is performed subsequent to the adjusting the optical element(s) of the second optical assembly at 714. In some such examples, the adjusting the optical element(s) of the second optical assembly at 714 is performed when the CPM system is in an initial configuration in which the charged particle beam is focused at the detector plane. In such examples, the adjusting the optical element(s) of the second optical assembly at 714 may include adjusting such that the charged particle beam becomes unfocused (and/or increasingly unfocused) at the detector. This is not required of all examples, however. For example, it also is within the scope of the present disclosure that the adjusting the optical element(s) of the second optical assembly at 714 may be performed when the CPM system is in an initial configuration in which the charged particle beam is underfocused or overfocused relative to the detector plane.

In general, and as discussed above, it may be initially unknown whether the charged particle beam is underfocused or overfocused in the initial configuration of the CPM system. Accordingly, the adjusting the optical element(s) of the second optical assembly at 714 can include iteratively adjusting the optical elements, measuring the effect of each adjustment, and performing subsequent adjustments based upon the measured effect.

For example, at any given configuration of the second optical assembly, the method 700 can include operating the beam deflector between an unblanked state and a blanked state (e.g., a partially blanked state or a fully blanked state) and recording an initial streak length formed by the charged particle beam in the detector plane as the beam deflector is operated between the unblanked state and the blanked state. Recording the streak length can be performed in any suitable manner, such as in a manner described herein with reference to FIG. 4.

The adjusting the optical element(s) of the second optical assembly at 714 can then include adjusting a focal length of the second optical assembly in a first direction, such as to move the conjugate deflector plane in the upstream direction, and recording an updated streak length as the beam deflector is operated between the unblanked state and the blanked state. If the updated streak length is less than the initial streak length, the adjusting the optical element(s) of the second optical assembly at 714 can be performed to move the conjugate deflector plane further in the first direction and measuring a new updated streak length. If the updated streak length is greater than the initial streak length, the adjusting the optical element(s) of the second optical assembly at 714 can be performed to move the conjugate deflector plane in a second direction opposite to the first direction and measuring a new updated streak length. Such operations may be performed iteratively until the measured streak length is minimized, which can indicate that the conjugate deflector plane is axially aligned with the detector plane.

In a configuration in which the conjugate deflector plane is axially aligned with the detector plane, the charged particle beam may form a beam pattern that defocused at the deflector plane. The method 700 then may include performing the adjusting the optical element(s) of the first optical assembly at 720 in such a manner that the beam pattern regains and/or increases in focus at the detector.

The beam pattern at the detector can refer to any suitable form and/or pattern of the charged particle beam in the detector plane independent of whether the charged particle beam is modulated by a specimen at the specimen plane. For example, the beam pattern at the detector may include and/or be a modulated beam pattern, which in turn may refer to any suitable portion and/or feature of the charged particle beam downstream of a specimen that is deflected (e.g., diffracted) and/or otherwise altered via interaction with the specimen, such as the modulated electron beam 202' of FIG. 2. Additionally, or alternatively, the beam pattern at the detector may include and/or be ay suitable portion and/or feature of the charged particle beam that is substantially unmodified by interaction with a specimen.

In the present disclosure, a degree of focus of the beam pattern and/or of a feature thereof in a given plane may be characterized by a characteristic (e.g., maximum) diameter of the beam pattern in the given plane. In particular, a degree of focus may be described as being increased and/or improved when such a characteristic diameter is reduced.

The recording the diffracted beam pattern at 730 may be performed in any suitable manner. For example, the diffracted beam pattern recorded by the detector may include and/or be any suitable pattern, such as a diffraction pattern (e.g., a diffractogram) that includes diffraction spots, rings, discs, etc. The detector may include and/or be any suitable detector, such as the TEM camera 130 of FIG. 1, the detector 280 of FIG. 2, and/or the detector 322 of FIGS. 3A-3C. The recording the diffracted beam pattern at 730 may be performed with a specimen positioned in the specimen plane such that the specimen modulates the charged particle beam to produce the diffracted beam pattern. As discussed above, however, other aspects of the method 700 may be performed when the specimen is positioned in the specimen plane or when the specimen is removed from the specimen plane.

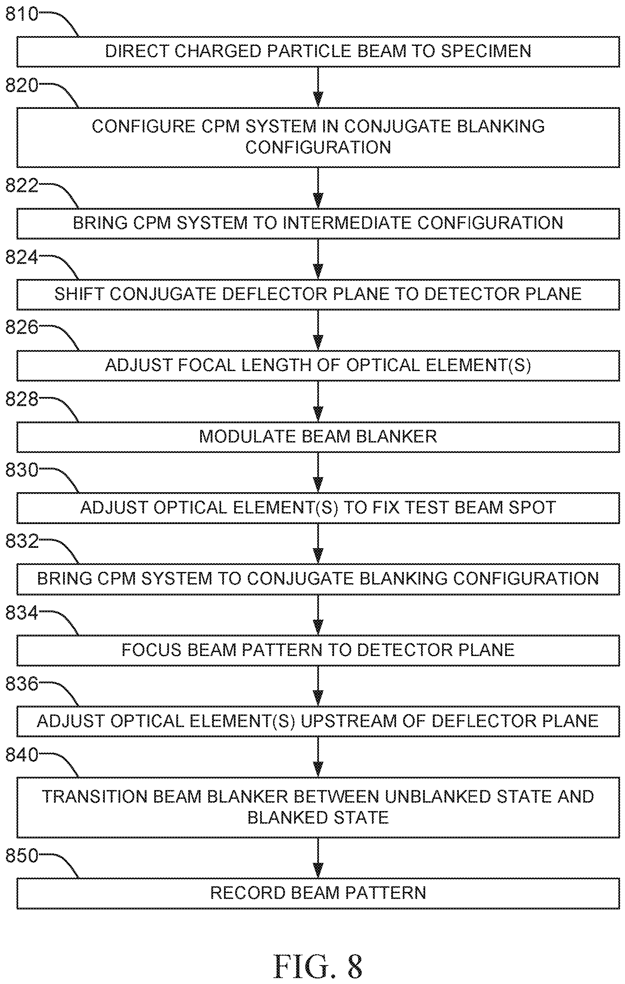

FIG. 8 is a flowchart depicting additional examples of a method 800 of operating a CPM system according to the present disclosure. The method 800 may be performed in conjunction with any suitable CPM system. For example, the CPM system can include and/or be the CPM system 100 of FIG. 1, the TEM 200 of FIG. 2, and/or the TEM 300 of FIGS. 3A-3C, and/or any suitable portions thereof. The CPM system additionally or alternatively can include any suitable features and/or characteristics not specifically described herein.

Any of the system components discussed and/or described herein with reference to the method 800 may be understood as representing and/or referring to similarly named components of the CPM system 100, the TEM 200 and/or the TEM 300 and/or to functional equivalents thereof. For example, the beam deflector described herein with reference to the method 800 can represent the deflector 112 of FIG. 1, the beam deflector 216 of FIG. 2, and/or the beam deflector 314 of FIGS. 3A-3C. In this manner, the method 800 may be understood in the context of the above descriptions of the CPM system 100, the TEM 200, and/or the TEM 300, and vice versa. This is not required, however, and it additionally is within the scope of the present disclosure that the method 800 may be performed in conjunction with any suitable components.

Additionally, any of the methods disclosed herein with reference to FIG. 8 also may be described as including and/or representing any of the method steps disclosed herein with reference to FIG. 7, and vice versa. For example, the method 700 and the method 800 may include steps that are performed in substantially similar manners and/or that produce similar effects.

As shown in FIG. 8, the method 800 includes directing, 810, a charged particle beam to a specimen that modulates the charged particle beam to create a beam pattern downstream of the specimen. The method 800 additionally includes transitioning, at 840, a beam blanker of the CPM system between an unblanked state and a blanked state and recording, at 850, the beam pattern with a detector. When the beam blanker is in the unblanked state, the charged particle beam may reach the specimen and create the beam pattern downstream of the specimen. When the beam blanker is in the blanked state, the beam blanker directs the charged particle beam away from the specimen, such as in the manner discussed above with reference to FIG. 2.

The beam blanker also may be referred to as a beam deflector. Examples of a beam blanker that may be used in conjunction with the method 800 include the deflector 112 of FIG. 1, the beam deflector 216 of FIG. 2, and/or the beam deflector 314 of FIGS. 3A-3C. The beam blanker is positioned at a deflector plane, and the detector is positioned at a detector plane that is conjugate to the deflector plane, at least during the recording the beam pattern at 850.

At least during the recording the beam pattern at 850, the beam pattern can include one or more beam pattern features that are focused in the detector plane. Such beam pattern features can include and/or be spots, rings, discs, etc. With reference to FIG. 2, for example, the beam pattern features can include and or be the diffraction pattern 272 formed by the electron beam 202 and the modulated electron beam 202' in the detector plane 282.

The method 800 may be performed such that the beam pattern features are substantially stationary in the detector plane as the beam blanker transitions between the unblanked state and the blanked state. In this manner, and as discussed above, transitioning the beam blanker between the unblanked state and the blanked state can allow for exposing the beam pattern to the detector without introducing the streaking discussed above in the context of FIG. 4 and/or the feature blurring shown in FIG. 5A. As discussed above, this may be particularly beneficial in examples in which the beam blanker is used to perform ultrafast time-resolved studies of the specimen, such as by exposing the specimen to the electron beam for a time duration that is on the order of nanoseconds. As a more specific example, the method 800 may be performed with an electrostatic beam blanker and/or such that the transitioning the beam blanker at 840 is performed over a time period that is less than 10 nanoseconds (ns).

As shown in FIG. 8, the method 800 can include configuring, at 820, the CPM system in a conjugate blanking configuration, which may result in beam pattern features remaining substantially stationary as discussed above. When the CPM system is in the conjugate blanking configuration, the deflector plane is conjugate to the detector plane, and a crossover of the charged particle beam (e.g., a focal plane thereof) is positioned at (e.g., axially aligned with) the deflector plane.

In some examples, the configuring the CPM system at 820 may be at least partially performed subsequent to the directing the charged particle beam to the specimen at 810. In some such examples, aspects of the configuring the CPM system at 820 can include observing, measuring, and/or recording a portion of the charged particle beam in the deflector plane that is modulated (e.g., diffracted) by the specimen. Additionally, or alternatively, the configuring the CPM system at 820 may be at least partially performed prior to the directing the charged particle beam to the specimen at 810. In some such examples, aspects of the configuring the CPM system at 820 can include observing, measuring, and/or recording a portion of the charged particle beam in the deflector plane that is unmodified by the specimen and/or that did not interact with the specimen. As a more specific example, such aspects of the configuring the CPM system at 820 can be performed with the specimen removed from a beam path of the charged particle beam.

The configuring the CPM system at 820 may be performed in any of a variety of manners. For example, and as shown in FIG. 8, the configuring the CPM system at 820 can include bringing, at 822, the CPM system to an intermediate configuration, in which the detector plane is conjugate to the deflector plane. The configuring the CPM system at 820 additionally can include, subsequent to the bringing the CPM system to the intermediate configuration at 822, bringing, at 832, the CPM system to the conjugate blanking configuration. With reference to FIGS. 3A-3C, FIG. 3B may be described as illustrating an example of the intermediate configuration, while FIG. 3C may be described as illustrating an example of the conjugate blanking configuration.

In some examples, and as shown in FIG. 8, the bringing the CPM system to the intermediate configuration at 822 includes shifting, at 824, a conjugate deflector plane (e.g., the second conjugate deflector plane 342 of FIGS. 3A-3C) into axial alignment with the detector plane. In some examples, the bringing the CPM system to the intermediate configuration at 822 and/or the shifting the conjugate deflector plane at 824 can include adjusting a focal length of one or more optical elements downstream of the deflector plane, such as in any suitable manner discussed above.

The bringing the CPM system to the intermediate configuration at 822 can be performed in any suitable manner to confirm that the detector plane is conjugate to the deflector plane. For example, and as discussed above in the context of FIG. 3B, the intermediate configuration may represent a configuration in which a beam spot at the detector plane (e.g., of an undiffracted charged particle beam and/or of a feature of a diffracted beam pattern) is unfocused but substantially stationary as the beam blanker transitions between the unblanked state and the blanked state. The bringing the CPM system to the intermediate configuration at 822 thus may include defocusing (or modulating a focus of) the beam spot until the CPM system reaches a configuration in which the beam spot is substantially stationary during operation of the beam blanker.

As a more specific example, and with reference to FIG. 8, the bringing the CPM system to the intermediate configuration at 822 can include modulating, at 828, the beam blanker between the unblanked state and the blanked state to move a test beam pattern feature in the detector plane. For example, the modulating the beam blanker at 828 can include varying a deflection of the charged particle beam caused by the beam blanker, such as by varying and/or modulating a voltage applied to an electrostatic beam blanker. The test beam pattern feature can include and/or be any suitable feature and/or combination of features (e.g., spots, rings, discs, etc.) of the beam spot and/or pattern.

The modulating the beam blanker at 828 may be performed repeatedly (e.g., periodically), and may include modulating such that the beam blanker reaches the unblanked state and/or the (fully) blanked state. Additionally, or alternatively, the modulating the beam blanker at 828 may be performed such that the beam blanker is transitioned among a plurality of states between (but not inclusive of) unblanked state and/or the fully blanked state.

The bringing the CPM system to the intermediate configuration at 822 also can include adjusting, at 830, one or more optical elements downstream of the deflector plane to fix the test beam pattern feature to a location that is substantially stationary in the deflector plane during the modulating the beam blanker at 828.

The modulating the beam blanker at 828 and the adjusting the optical element(s) at 830 may be performed at least partially sequentially and/or at least partially concurrently. For example, the bringing the CPM system to the intermediate configuration at 822 can include modulating the beam blanker between the unblanked state and the blanked state to determine a degree to which the test beam pattern feature shifts in the detector plane during such modulation (e.g., by observing the test beam pattern feature with the detector). This degree of shifting can be characterized qualitatively and/or quantitatively, such as via manual observation and/or via measurement of a streak length associated with the streak (e.g., the streak length 412 of FIG. 4). The bringing the CPM system to the intermediate configuration at 822 then can include incrementally adjusting one or more optical elements to axially shift a conjugate deflector plane (e.g., the second conjugate deflector plane 342 of FIGS. 3A-3C) and repeating the modulating the beam blanker at 828 to determine whether the CPM system has reached the intermediate configuration. In particular, when the test beam pattern feature is observed to be substantially stationary in the detector plane during the modulating the beam blanker at 828, the CPM system may be understood to be in the intermediate configuration.

With the CPM system in the intermediate configuration, the bringing the CPM system to the conjugate blanking configuration at 832 can include focusing, at 834, the beam pattern to the detector plane, such as in the manner described above with reference to FIG. 3C. For example, the focusing the beam pattern at 834 can include adjusting, at 836, one or more optical elements upstream of the deflector plane to bring a crossover plane of the charged particle beam to the detector plane. As a more specific example, the adjusting the optical element(s) at 836 can include adjusting a focal length of a source module optical element, such as a gun lens, such that a diffraction plane of the charged particle beam is axially aligned with the detector plane. Such a configuration may be achieved, for example, when the focal length of the gun lens is such that a focal plane of the charged particle beam (e.g., the first crossover plane 330 of FIGS. 3A-3C) is brought into axial alignment with the deflector plane. Because the detector plane is conjugate to the deflector plane in the intermediate configuration, creating a beam crossover in the deflector plane results in a corresponding crossover being formed in the detector plane. This crossover plane at the detector plane in turn can correspond to a diffraction plane of the charged particle beam downstream of the specimen such that, in the conjugate blanking configuration, the diffraction pattern is brought into focus at the detector plane.

Any aspect of the method 700 and/or of the method 800 may be performed at least partially automatically, such as via a controller of the CPM system (e.g., the controller 150 of FIG. 1). For example, such a controller may be programmed and/or configured to receive an image and/or a corresponding signal from the detector, such as to determine whether the detector plane is conjugate to the deflector plane and/or axially aligned with a crossover plane as described herein. Additionally, or alternatively, the controller may be programmed and/or configured to control one or more optical elements of the CPM system, such as to vary a focal length of one or more electro-optical lenses and/or to selectively deflect the charged particle beam with the beam deflector. Additionally, or alternatively, the controller may be programmed and/or configured to perform various method steps that are iteratively repeated to achieve a desired configuration, such as the modulating the beam blanker at 828 and/or the adjusting the optical element(s) at 830.

FIG. 9 and the following discussion are intended to provide a brief, general description of an exemplary computing environment in which the disclosed technology may be implemented. In particular, some or all portions of this computing environment can be used with the above methods and apparatus to, for example, configure a CPM system to a conjugate blanking configuration, focus a charged particle beam upon a specimen, record a diffraction pattern, and/or perform any portions of the methods disclosed above.

Although not required, the disclosed technology is described in the general context of computer executable instructions, such as program modules, being executed by a personal computer (PC). Generally, program modules include routines, programs, objects, components, data structures, etc., that perform particular tasks or implement particular abstract data types. Moreover, the disclosed technology may be implemented with other computer system configurations, including hand-held devices, tablets, multiprocessor systems, microprocessor-based or programmable consumer electronics, network PCs, minicomputers, mainframe computers, virtual machines, containerized applications, Kubernetes clusters, and the like. The disclosed technology also may be practiced in distributed computing environments where tasks are performed by remote processing devices that are linked through a communications network. In a distributed computing environment, program modules may be located in both local and remote memory storage devices. In some cases, such processing is provided in a CPM system. The disclosed systems can serve to control image acquisition and provide a user interface as well as serve as an image processor.

With reference to FIG. 9, an exemplary system for implementing the disclosed technology includes a general-purpose computing device in the form of an exemplary conventional PC 900, including one or more processing units 902, a system memory 904, and a system bus 906 that couples various system components including the system memory 904 to the one or more processing units 902. The system bus 906 may be any of several types of bus structures including a memory bus or memory controller, a peripheral bus, and a local bus using any of a variety of bus architectures. The exemplary system memory 904 includes read-only memory (ROM) 908 and random-access memory (RAM) 910. A basic input/output system (BIOS) 912, containing the basic routines that help with the transfer of information between elements within the PC 900, is stored in ROM 908.

The exemplary PC 900 further includes one or more storage devices 930 such as a hard disk drive for reading from and writing to a hard disk, a magnetic disk drive for reading from or writing to a removable magnetic disk, and an optical disk drive for reading from or writing to a removable optical disk (such as a CD-ROM or other optical media). Such storage devices can be connected to the system bus 906 by a hard disk drive interface, a magnetic disk drive interface, and an optical drive interface, respectively. The drives and their associated computer readable media provide nonvolatile storage of computer-readable instructions, data structures, program modules, and other data for the PC 900. Other types of computer-readable media which can store data that is accessible by a PC, such as magnetic cassettes, flash memory cards, solid-state drives, digital video disks, CDs, DVDs, RAMs, ROMs, and the like, may also be used in the exemplary operating environment.

A number of program modules may be stored in the storage devices 930 including an operating system, multiple operating systems, virtual operating systems, one or more application programs, other program modules, and/or program data. In some examples, one or more aspects of the methods disclosed herein may be programmed, implemented, encoded, trained, and/or otherwise transferred to the program modules via machine learning, neural networks, artificial intelligence, etc.

The exemplary PC 900 can include various devices configured for user interface. For example, a user may enter commands and information into the PC 900 through one or more input devices 940 such as a keyboard and/or a pointing device such as a mouse. For example, the user may enter commands to initiate image acquisition and/or to initiate one or more methods disclosed herein. Other input devices may include a digital camera, microphone, joystick, game pad, buttons, dials, satellite dish, scanner, or the like. In some examples, several such input devices can be integrated into a single user interface device, such as may be commonly used in conjunction with a CPM system. These and other input devices are often connected to the one or more processing units 902 through a serial port interface that is coupled to the system bus 906, but may be connected by other interfaces such as a parallel port, game port, universal serial bus (USB), or wired or wireless network connection. A monitor 946 or other type of display device is also connected to the system bus 906 via an interface, such as a video adapter, and can display, for example, one or more images of a sample or specimen prior to, subsequent to, and/or during performance of one or more methods disclosed herein. The monitor 946 can also be used to select sections for processing or particular image alignment and alignment procedures such as correlation, feature identification, and preview area selection or other image selection. Other peripheral output devices, such as speakers and printers (not shown), may be included.

The PC 900 may operate in a networked environment using logical connections to one or more remote computers, such as a remote computer 960. In some examples, one or more network or communication connections 950 are included. The remote computer 960 may be another PC, a server, a router, a network PC, and/or a peer device or other common network node, and typically includes many or all of the elements described above relative to the PC 900, although only a memory storage device 862 has been illustrated in FIG. 9. The personal computer 900 and/or the remote computer 960 can be connected to a local area network (LAN) and/or a wide area network (WAN). Such networking environments are commonplace in offices, enterprise wide computer networks, intranets, and the Internet.

As shown in FIG. 12, a memory 990 (or portions of this or other memory) can store processor-executable instructions for beam focus control, beam deflector control, pattern recognition and analysis (e.g., to detect and/or characterize motion of a beam feature in a detector plane), etc. For example, such processor-executable instructions can, when executed by a processor system, cause the PC 900 and/or another component (e.g., any suitable components of the CPM system 100 of FIG. 1, the TEM 200 of FIG. 2, and/or the TEM 300 of FIGS. 3A-3C) to execute any of the methods disclosed herein. In some examples, processor-executable instructions can produce displayed images (e.g., of recorded diffraction patterns), processing of preview images, and/or acquisition of additional images.

### General Considerations

As used in this application and in the claims, the singular forms "a," "an," and "the" include the plural forms unless the context clearly dictates otherwise. Additionally, the term "includes" means "comprises." Further, the term "coupled" does not exclude the presence of intermediate elements between the coupled items.

Unless otherwise stated, as used herein, the term "substantially" means the listed value and/or property and any value and/or property that is at least 75% of the listed value and/or property. Equivalently, the term "substantially" means the listed value and/or property and any value and/or property that differs from the listed value and/or property by at most 25%. For example, "substantially equal" refers to quantities that are fully equal, as well as to quantities that differ from one another by up to 25%.

The systems, apparatus, and methods described herein should not be construed as limiting in any way. Instead, the present disclosure is directed toward all novel and non-obvious features and aspects of the various disclosed examples, alone and in various combinations and subcombinations with one another. The disclosed systems, methods, and apparatus are not limited to any specific aspect or feature or combinations thereof, nor do the disclosed systems, methods, and apparatus require that any one or more specific advantages be present or problems be solved. Any theories of operation are to facilitate explanation, but the disclosed systems, methods, and apparatus are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one of ordinary skill in the art.

In some examples, values, procedures, and the like may be characterized by qualifying terms such as "lowest," "best," "minimum," "extreme," etc. It is to be understood that such descriptions are intended to indicate that a selection among many used functional alternatives can be made, and such selections need not be better, smaller, or otherwise preferable to other selections.

The innovations can be described in the general context of computer-executable instructions, such as those included in program modules, being executed in a computing system on a target real or virtual processor. Generally, program modules or components include routines, programs, libraries, objects, classes, components, data structures, etc. that perform particular tasks or implement particular abstract data types. The functionality of the program modules may be combined or split between program modules as desired in various examples. Computer-executable instructions for program modules may be executed within a local or distributed computing system. In general, a computing system or computing device can be local or distributed, and can include any combination of special-purpose hardware and/or general-purpose hardware with software implementing the functionality described herein, examples of which include personal computers, hand-held devices, tablets, multiprocessor systems, microprocessor-based or programmable consumer electronics, network PCs, minicomputers, mainframe computers, virtual machines, containerized applications, Kubernetes clusters, etc.

In various examples described herein, a module (e.g., component or engine) can be "programmed" and/or "coded" to perform certain operations or provide certain functionality, indicating that computer-executable instructions for the module can be executed to perform such operations, cause such operations to be performed, or to otherwise provide such functionality. Although functionality described with respect to a software component, module, or engine can be carried out as a discrete software unit (e.g., program, function, class method), it need not be implemented as a discrete unit. That is, the functionality can be incorporated into a larger or more general-purpose program, such as one or more lines of code in a larger or general-purpose program.

Described algorithms may be, for example, embodied as software or firmware instructions carried out by a digital computer. For instance, any of the disclosed methods can be performed by one or more a computers or other computing hardware that is part of a microscopy tool. The computers can be computer systems comprising one or more processors (processing devices) and tangible, non-transitory computer-readable media (e.g., one or more optical media discs, volatile memory devices (such as DRAM or SRAM), or nonvolatile memory or storage devices (such as hard drives, NVRAM, and solid-state drives (e.g., Flash drives)). The one or more processors can execute computer-executable instructions stored on one or more of the tangible, non-transitory computer-readable media, and thereby perform any of the disclosed techniques. For instance, software for performing any of the disclosed examples can be stored on the one or more volatile, non-transitory computer-readable media as computer-executable instructions, which when executed by the one or more processors, cause the one or more processors to perform any of the disclosed techniques or subsets of techniques.

Having described and illustrated the principles of the disclosed technology with reference to the illustrated examples, it will be recognized that the illustrated examples can be modified in arrangement and detail without departing from such principles. For instance, elements of examples performed in software may be implemented in hardware and vice-versa. Also, the technologies from any example can be combined with the technologies described in any one or more of the other examples. It will be appreciated that procedures and functions such as those described with reference to the illustrated examples can be implemented in a single hardware or software module, or separate modules can be provided. The particular arrangements above are provided for convenient illustration, and other arrangements can be used.

### Additional Examples of the Disclosed Technology

In view of the above-described implementations of the disclosed subject matter, this application discloses the additional examples enumerated below. It should be noted that one feature of an example in isolation or more than one feature of the example taken in combination with and. optionally, in combination with one or more feature of one or more further examples are further examples also falling within the disclosure of this application.

Example 1. A method of operating a charged particle microscope (CPM) system comprising a beam deflector positioned at a deflector plane, the CPM system configured to direct a charged particle beam to a specimen to produce a diffracted beam pattern at a diffraction plane, the method comprising: adjusting one or more optical elements of the CPM system such that the deflector plane is conjugate to the diffraction plane; and recording the diffracted beam pattern with a detector positioned at the diffraction plane.

Example 2. The method of example 1, wherein the adjusting the one or more optical elements comprises adjusting a position of the diffraction plane to bring the diffraction plane into axial alignment with the detector.

Example 3. The method of example 2, wherein the CPM system comprises a first optical assembly positioned upstream of the deflector plane and a second optical assembly positioned downstream of the deflector plane, wherein the adjusting the position of the diffraction plane comprises adjusting one or more optical elements of the second optical assembly.

Example 4. The method of example 3, wherein the method further comprises adjusting one or more optical elements of the first optical assembly to bring a crossover plane of the charged particle beam into axial alignment with the detector.

Example 5. The method of any one of examples 3-4, wherein the adjusting the one or more optical elements of the first optical assembly is performed subsequent to the adjusting the one or more optical elements of the second optical assembly.

Example 6. The method of any one of examples 3-5, wherein the adjusting the one or more optical elements of the first optical assembly is performed prior to the adjusting the one or more optical elements of the second optical assembly.

Example 7. The method of any one of examples 3-6, wherein the CPM system is configured to produce a modulated beam pattern at the detector, and wherein the adjusting the one or more optical elements of the second optical assembly comprises adjusting such that the modulated beam pattern is increasingly unfocused at the detector.

Example 8. The method of any one of examples 3-7, wherein the adjusting the one or more optical elements of the first optical assembly comprises adjusting a first focal length associated with the first optical assembly.

Example 9. The method of example 8, wherein the adjusting the one or more optical elements of the second optical assembly comprises adjusting a second focal length associated with the second optical assembly.

Example 10. The method of any one of examples 7-9, wherein one or both of the adjusting the first focal length and the adjusting the second focal length comprises adjusting an excitation voltage that is applied to an electro-optical lens.

Example 11. The method of any one of examples 3-10, wherein the CPM system comprises a source optics assembly configured to accelerate the charged particle beam toward the specimen, and wherein the first optical assembly comprises at least a portion of the source optics assembly.

Example 12. The method of any one of examples 3-11, wherein the second optical assembly comprises at least a portion of a condenser optics assembly of the CPM system.

Example 13. The method of any one of examples 3-12, wherein the second optical assembly comprises at least a portion of an objective optics assembly.

Example 14. The method of any one of examples 3-13, wherein the adjusting the one or more optical elements of the second optical assembly comprises adjusting one or more optical elements positioned downstream of the specimen.

Example 15. The method of any one of examples 3-14, wherein the second optical assembly comprises one or more objective lens elements.

Example 16. The method of any one of examples 3-15, wherein the adjusting the position of the diffraction plane comprises shifting the position of the diffraction plane in an axial direction.

Example 17. The method of any one of examples 1-16, wherein the diffracted beam pattern comprises a diffractogram.

Example 18. The method of any one of examples 1-17, further comprising operating the beam deflector to direct the charged particle beam to the specimen in the form of beam pulses of variable beam pulse duration and to vary the beam pulse durations to perform time-resolved diffraction studies of the specimen.

Example 19. The method of any one of examples 1-18, wherein the CPM system is configured such that the charged particle beam is at least substantially undeflected by the beam deflector when the beam deflector is in an unblanked state, wherein the beam deflector is configured to selectively deflect the charged particle beam away from the specimen when the beam deflector is in a fully blanked state, wherein the beam deflector is configured to direct the charged particle beam along a trajectory that yields a partially blanked beam pattern at the diffraction plane when the beam deflector is in any of a plurality of partially blanked states defined between the unblanked state and the fully blanked state, and wherein the method comprises operating the CPM system such that the partially blanked beam pattern is substantially stationary in the deflector plane as the beam deflector transitions from the unblanked state to the fully blanked state.

Example 20. The method of any one of examples 1-19, wherein the adjusting the one or more optical elements of the CPM system is at least partially performed while the specimen is positioned in a beam path of the charged particle beam.

Example 21. The method of any one of examples 1-20, wherein the adjusting the one or more optical elements of the CPM system is at least partially performed while the specimen is removed from a beam path of the charged particle beam.

Example 22. A method of operating a charged particle microscope (CPM) system, the method comprising: directing a charged particle beam to a specimen that modulates the charged particle beam to create a beam pattern downstream of the specimen; transitioning a beam blanker of the CPM system that is positioned at a deflector plane between an unblanked state, in which the charged particle beam reaches the specimen, and a blanked state, in which the charged particle beam is directed away from the specimen; and recording the beam pattern with a detector positioned at a detector plane that is conjugate to the deflector plane, wherein the beam pattern comprises one or more beam pattern features that are focused in the detector plane, and wherein the one or more beam pattern features are substantially stationary in the detector plane as the beam blanker transitions between the unblanked state and the blanked state.

Example 23. The method of example 22, wherein the beam blanker comprises an electrostatic beam blanker.

Example 24. The method of any one of examples 22-23, wherein the transitioning the beam blanker between the unblanked state and the blanked state is performed over a time period that is less than 10 nanoseconds (ns).

Example 25. The method of any one of examples 22-24, further comprising configuring the CPM system in a conjugate blanking configuration, in which the deflector plane is conjugate to the detector plane and in which a crossover of the charged particle beam is positioned at the deflector plane, and wherein the configuring the CPM system comprises: bringing the CPM system to an intermediate configuration, in which the detector plane is conjugate to the deflector plane; and subsequent to the bringing the CPM system to the intermediate configuration, bringing the CPM system to the conjugate blanking configuration.

Example 26. The method of example 25, wherein the configuring the CPM system in the conjugate blanking configuration is at least partially performed prior to the directing the charged particle beam to the specimen.

Example 27. The method of any one of examples 25-26, wherein the configuring the CPM system in the conjugate blanking configuration is at least partially performed subsequent to the directing the charged particle beam to the specimen.

Example 28. The method of any one of examples 25-27, wherein the bringing the CPM system to the intermediate configuration comprises shifting a conjugate deflector plane into axial alignment with the detector plane.

Example 29. The method of any one of examples 25-28, wherein the bringing the CPM system to the intermediate configuration comprises adjusting a focal length of one or more optical elements downstream of the deflector plane.

Example 30. The method of any one of examples 25-29, wherein the bringing the CPM system to the intermediate configuration comprises: modulating the beam blanker between the unblanked state and the blanked state to move a test beam pattern feature of the one or more beam pattern features in the detector plane; and adjusting one or more optical elements downstream of the deflector plane to fix the test beam pattern feature to a location that is substantially stationary in the deflector plane during the modulating the beam blanker between the unblanked state and the blanked state.

Example 31. The method of example 30, wherein the modulating the beam blanker and the adjusting the one or more optical elements downstream of the deflector plane are performed at least partially concurrently.

Example 32. The method of any one of examples 25-31, wherein the bringing the CPM system to the conjugate blanking configuration comprises, with the CPM system in the intermediate configuration, focusing the beam pattern to the detector plane.

Example 33. The method of example 32, wherein the focusing the beam pattern comprises adjusting one or more optical elements upstream of the deflector plane to bring a crossover plane of the charged particle beam to the detector plane.

Example 34. The method of any one of examples 32-33, wherein the focusing the beam pattern to the detector plane comprises adjusting a focal length of one or more optical elements upstream of the deflector plane.

Example 35. The method of any one of examples 18-34, further comprising operating the beam blanker to direct the charged particle beam to the specimen in the form of beam pulses of variable beam pulse duration and to vary the beam pulse durations to perform time-resolved diffraction studies of the specimen.

Example 36. A charged particle microscope (CPM) system, comprising: a charged particle source configured to emit a charged particle beam along an optical axis toward a specimen; a first optical assembly positioned downstream of the charged particle source and configured to vary an axial position of a focal plane of the charged particle beam upstream of the specimen; a beam deflector positioned at a deflector plane downstream of the first optical assembly and configured to selectively divert the charged particle beam away from the specimen; a second optical assembly positioned downstream of the deflector plane; and a detector positioned at a detector plane downstream of the second optical assembly, wherein the CPM system is configured such that the charged particle beam exhibits a beam crossover at the deflector plane and such that the deflector plane is imaged onto the detector.

Example 37. The CPM system of example 36, wherein the first optical assembly comprises a gun lens configured to adjust an axial position of the beam crossover, and wherein the CPM system is configured such that the gun lens remains at a fixed excitation during operative use of the CPM system.

Example 38. The CPM system of any one of examples 36-37, wherein the second optical assembly comprises one or both of a condenser optics assembly and an objective optics assembly.

Example 39. The CPM system of any one of examples 36-38, wherein one or more components of the second optical assembly are positioned downstream of the specimen.

Example 40. The CPM system of any one of examples 36-39, further comprising a blanking aperture, wherein the beam deflector is configured to selectively direct the charged particle beam to be blocked by the blanking aperture.

Example 41. The CPM system of example 40, wherein the second optical assembly comprises the blanking aperture.

Example 42. The CPM system of any one of examples 36-41, wherein the beam deflector is configured to direct the charged particle beam to the specimen in the form of beam pulses of variable beam pulse duration to perform time-resolved diffraction studies of the specimen.

The features described herein with regard to any example can be combined with other features described in any one or more of the other examples, unless otherwise stated. For example, any one or more of the steps and/or features of one method can be combined with any one or more steps and/or features of another method.

In view of the many possible ways in which the principles of the disclosure may be applied, it should be recognized that the illustrated configurations depict examples of the disclosed technology and should not be taken as limiting the scope of the disclosure nor the claims. Rather, the scope of the claimed subject matter is defined by the following claims and their equivalents.

## Claims

1. A method of operating a charged particle microscope (CPM) system comprising a beam deflector positioned at a deflector plane, the CPM system configured to direct a charged particle beam to a specimen to produce a diffracted beam pattern at a diffraction plane, the method comprising:
adjusting one or more optical elements of the CPM system such that the deflector plane is conjugate to the diffraction plane; and
recording the diffracted beam pattern with a detector positioned at the diffraction plane.

2. The method of claim 1, wherein the adjusting the one or more optical elements comprises adjusting a position of the diffraction plane to bring the diffraction plane into axial alignment with the detector.

3. The method of claim 2, wherein the CPM system comprises a first optical assembly positioned upstream of the deflector plane and a second optical assembly positioned downstream of the deflector plane, wherein the adjusting the position of the diffraction plane comprises adjusting one or more optical elements of the second optical assembly, and wherein the method further comprises adjusting one or more optical elements of the first optical assembly to bring a crossover plane of the charged particle beam into axial alignment with the detector.

4. The method of claim 3, wherein the adjusting the one or more optical elements of the first optical assembly is performed subsequent to the adjusting the one or more optical elements of the second optical assembly.

5. The method of any of claims 3-4, wherein the adjusting the one or more optical elements of the first optical assembly comprises adjusting a first focal length associated with the first optical assembly, and wherein the adjusting the one or more optical elements of the second optical assembly comprises adjusting a second focal length associated with the second optical assembly.

6. The method of any of claims 3-5, wherein the CPM system comprises a source optics assembly configured to accelerate the charged particle beam toward the specimen, and wherein the first optical assembly comprises at least a portion of the source optics assembly.

7. The method of any of claims 3-6, wherein the second optical assembly comprises at least a portion of a condenser optics assembly of the CPM system.

8. The method of any of claims 3-7, wherein the second optical assembly comprises at least a portion of an objective optics assembly.

9. The method of any of claims 3-8, wherein the adjusting the position of the diffraction plane comprises shifting the position of the diffraction plane in an axial direction.

10. The method of any of claims 1-9, wherein the CPM system is configured such that the charged particle beam is at least substantially undeflected by the beam deflector when the beam deflector is in an unblanked state, wherein the beam deflector is configured to selectively deflect the charged particle beam away from the specimen when the beam deflector is in a fully blanked state, wherein the beam deflector is configured to direct the charged particle beam along a trajectory that yields a partially blanked beam pattern at the diffraction plane when the beam deflector is in any of a plurality of partially blanked states defined between the unblanked state and the fully blanked state, and wherein the method comprises operating the CPM system such that the partially blanked beam pattern is substantially stationary in the deflector plane as the beam deflector transitions from the unblanked state to the fully blanked state.

11. A charged particle microscope (CPM) system, comprising:
a charged particle source configured to emit a charged particle beam along an optical axis toward a specimen;
a first optical assembly positioned downstream of the charged particle source and configured to vary an axial position of a focal plane of the charged particle beam upstream of the specimen;
a beam deflector positioned at a deflector plane downstream of the first optical assembly and configured to selectively divert the charged particle beam away from the specimen;
a second optical assembly positioned downstream of the deflector plane and configured to vary an axial position of a focal plane of the charged particle beam downstream of the specimen; and
a detector positioned at a detector plane downstream of the second optical assembly,
wherein the CPM system is configured such that the charged particle beam exhibits a beam crossover at the deflector plane such that the deflector plane is conjugate to the diffraction plane and such that the deflector plane is imaged onto the detector.

12. The CPM system of claim 11, wherein the first optical assembly comprises a gun lens configured to adjust an axial position of the beam crossover, and wherein the CPM system is configured such that the gun lens remains at a fixed excitation during operative use of the CPM system.

13. The CPM system of any of claims 11-12, wherein the second optical assembly comprises one or both of a condenser optics assembly and an objective optics assembly.

14. The CPM system of any of claims 11-13, wherein one or more components of the second optical assembly are positioned downstream of the specimen.

15. The CPM system of any of claims 11-14, further comprising a blanking aperture, wherein the beam deflector is configured to selectively direct the charged particle beam to be blocked by the blanking aperture.
